# EUROPÄISCHE PATENTANMELDUNG

(11) **EP 4 651 120 A1**
(43) Veröffentlichungstag der Anmeldung: **19.11.2025**
(21) Anmeldenummer: 25176035.1
(22) Anmeldetag: 13.05.2025
(51) Int. Cl.: G09G 3/04, G09G 3/14, G09F 9/302, G09F 9/30, G09F 9/33

(54) **ANZEIGEEINRICHTUNG, ANZEIGESYSTEM, MULTIFUNKTIONSELEMENT UND VERFAHREN ZUM HERSTELLEN EINER ANZEIGEEINRICHTUNG**

(30) Priorität: 13.05.2024 DE 102024204420
(71) Anmelder: Fraunhofer-Gesellschaft zur Förderung der angewandten Forschung e.V., 80686 München (DE)
(72) Erfinder: JANK, Michael, 91058 Erlangen (DE); JOCH, Daniel, 91058 Erlangen (DE); LANG, Thomas, 91058 Erlangen (DE)
(74) Vertreter: König, Andreas Rudolf

(57) **Zusammenfassung**

Eine Anzeigeeinrichtung (10) umfasst eine Vielzahl von Anzeigeelementen (12_1 - 12_20) und eine Verschaltungseinrichtung (14), die ausgebildet ist, um unterschiedliche und disjunkte Teilmengen der Anzeigeelemente miteinander zu verschalten. Anzeigeelemente einer Teilmenge sind vermittels der Verschaltungseinrichtung gemeinsam ansteuerbar.

## Beschreibung

Die vorliegende Erfindung bezieht sich auf eine Anzeigeeinrichtung, auf ein Anzeigesystem mit einer solchen Anzeigeeinrichtung, auf ein Multifunktionselement mit einem Anzeigesystem und auf ein Verfahren zum Herstellen einer Anzeigeeinrichtung. Die vorliegende Erfindung bezieht sich insbesondere auf die Darstellung von einfachen Symbolen.

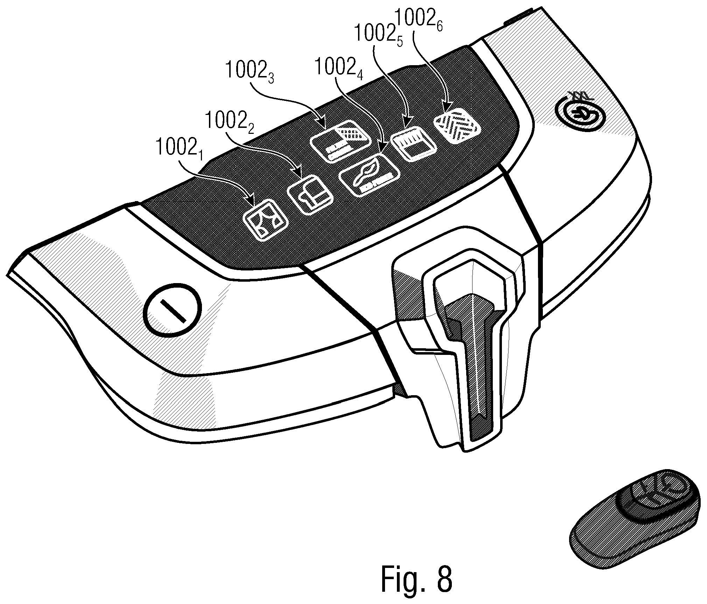

Bezüglich Displaytechnologie für hochauflösende Anzeigen existieren bevorzugt Lösungen mit individueller Ansteuerung der Leuchtflächen (Pixel). Dies beinhaltet Passiv-Matrix-Anzeigen, bei denen zwischen Anode und Kathode eines Leucht- oder helligkeitsregulierenden Elements (Leuchtdiode / LED, organische Leuchtdiode / OLED, Flüssigkristall / LC) direkt eine gewünschte Spannung angelegt wird, um die Emission oder Transmission von Licht zu ermöglichen (vgl. [1], Fig. 13 i. V. m. Figs. 12 und 8). Dabei ist, wie in [1], Fig. 13 zu sehen, jeweils nur eine Zeile aktiv leuchtend, das Gesamtbild ergibt sich durch schnelles Umschalten zwischen den Zeilen unter Ausnutzung der Trägheit des menschlichen Auges oder des Aktivelements (z.B. Nachleuchten LED, Zurücksetzen LC). Um bei großen Anzeigeelementen eine vollständige Darstellung ohne Flackern zu erreichen, werden die angelegten Pixelspannungen und damit die Helligkeit des Leuchtelements über eine Hilfsschaltung aus Treiber-Element (Transistor) und Speicherkondensator so lange aufrechterhalten, bis die Zeile neu beschrieben wird. Die entsprechende Verschaltung wird als Aktiv-Matrix-Schaltung bezeichnet (vgl. [1], Figs. 14 und 16).

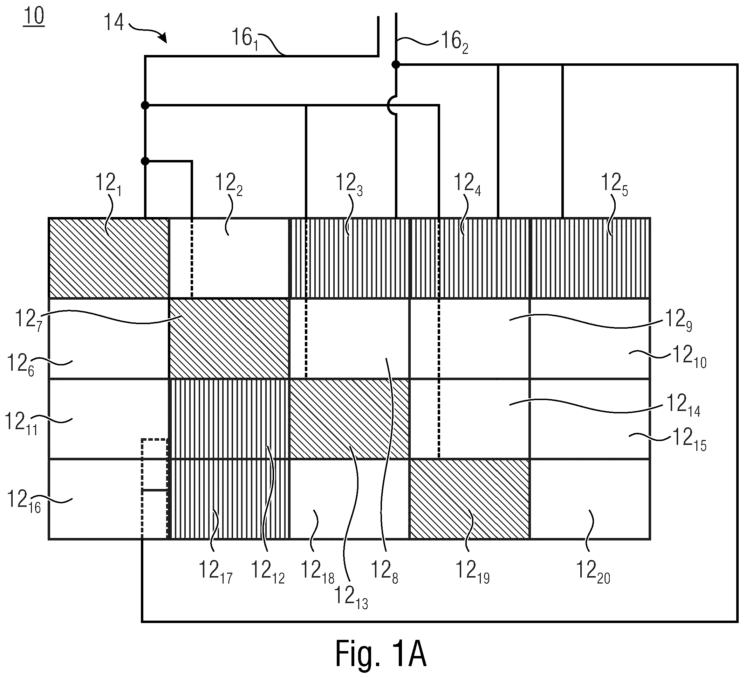

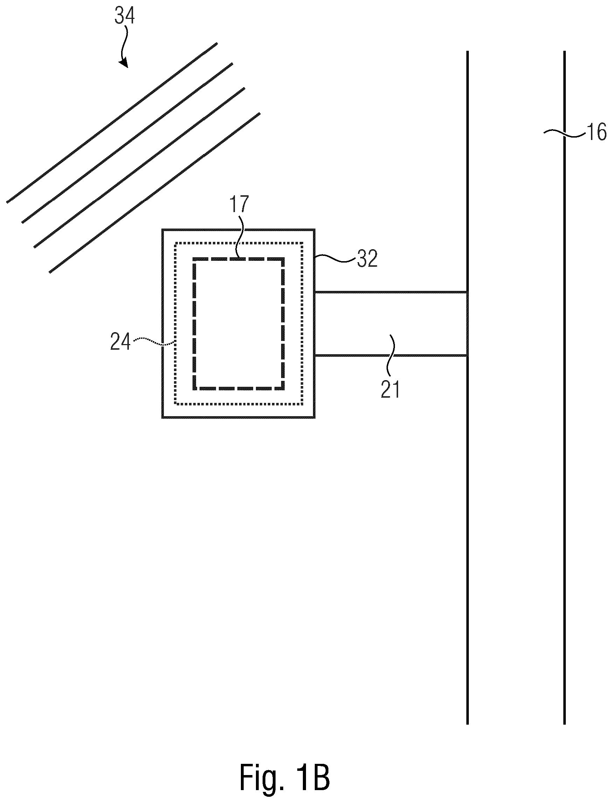

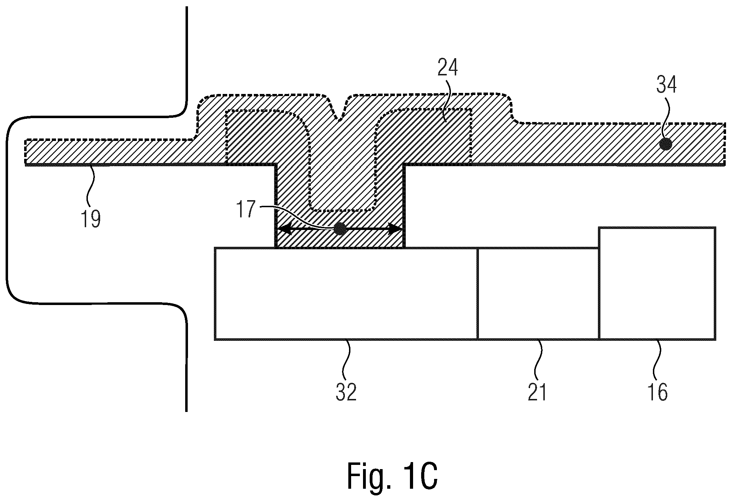

Beide Matrix-Treiber-Varianten besitzen für jede Zeile und jede Spalte eine Anschlussleitung, bei n x k Leuchtelementen resultieren hieraus n + k Ansteuerleitungen, die von entsprechenden Treiber-Schaltungen (ICs) zeitlich synchronisiert versorgt werden. ([1], Fig. 11). Mit diesen Anzeigen lassen sich entsprechend der Auflösung wahlfrei statische oder bewegte Bilder (Videos) anzeigen. Für die Aufbereitung aus gängigen Quellen und die Bereitstellung der Energieversorgung sind weitere IC-Bausteine notwendig ([1], Fig. 20 und [2], Fig. 1).

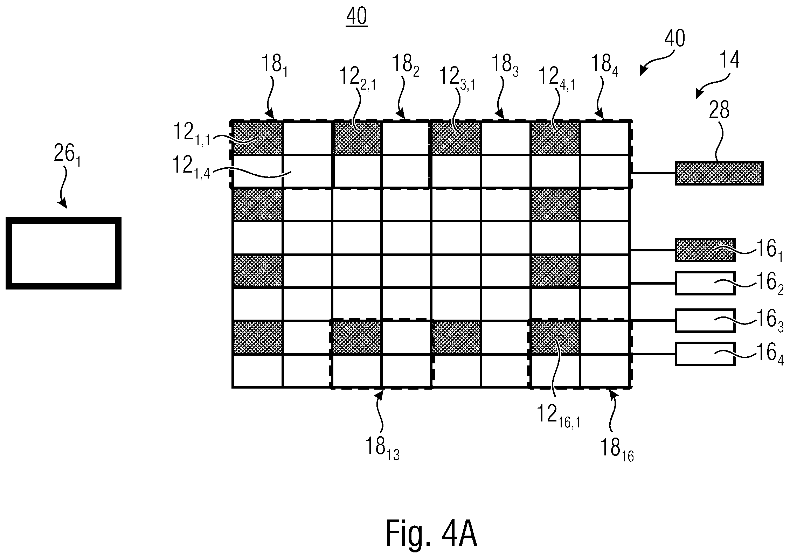

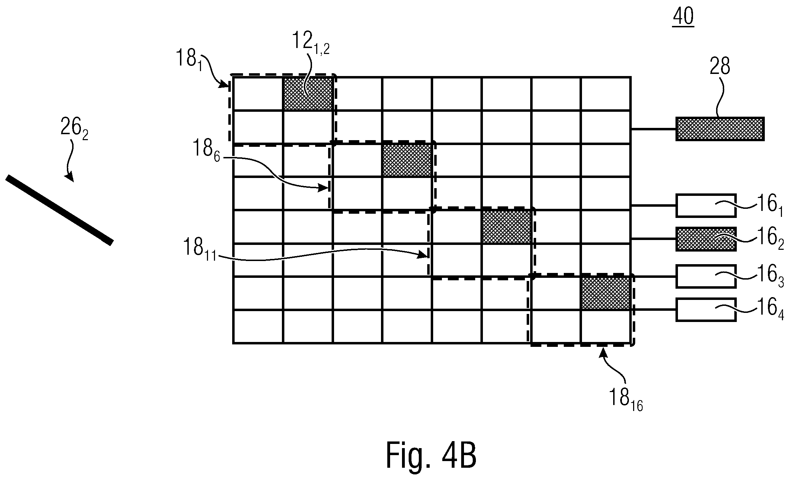

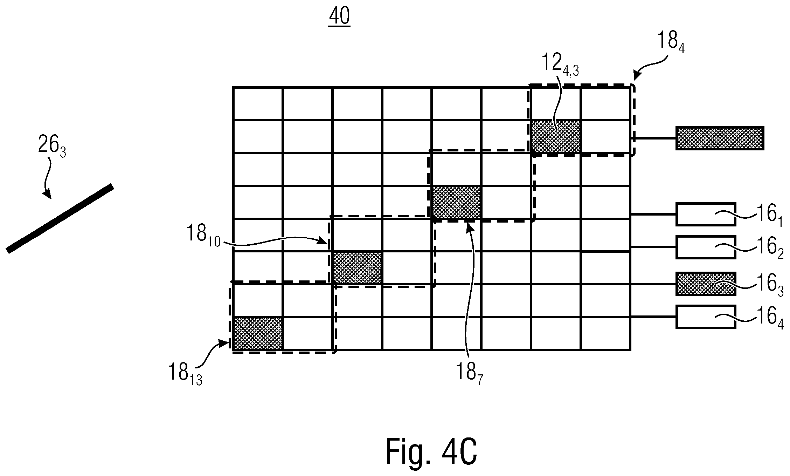

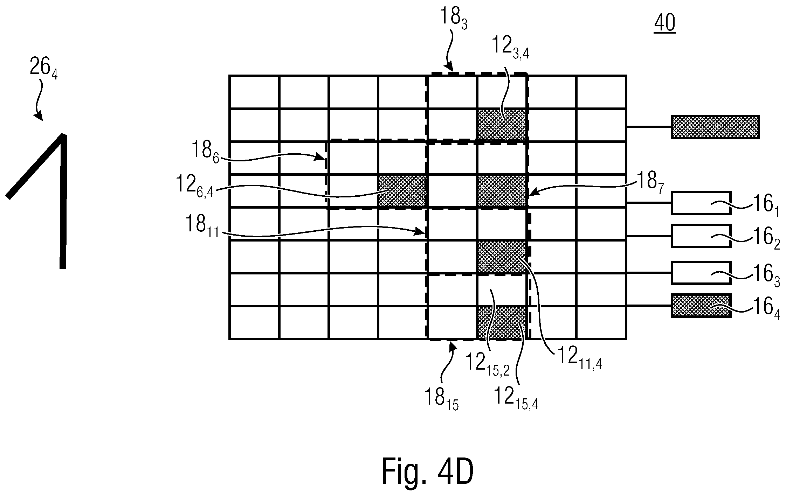

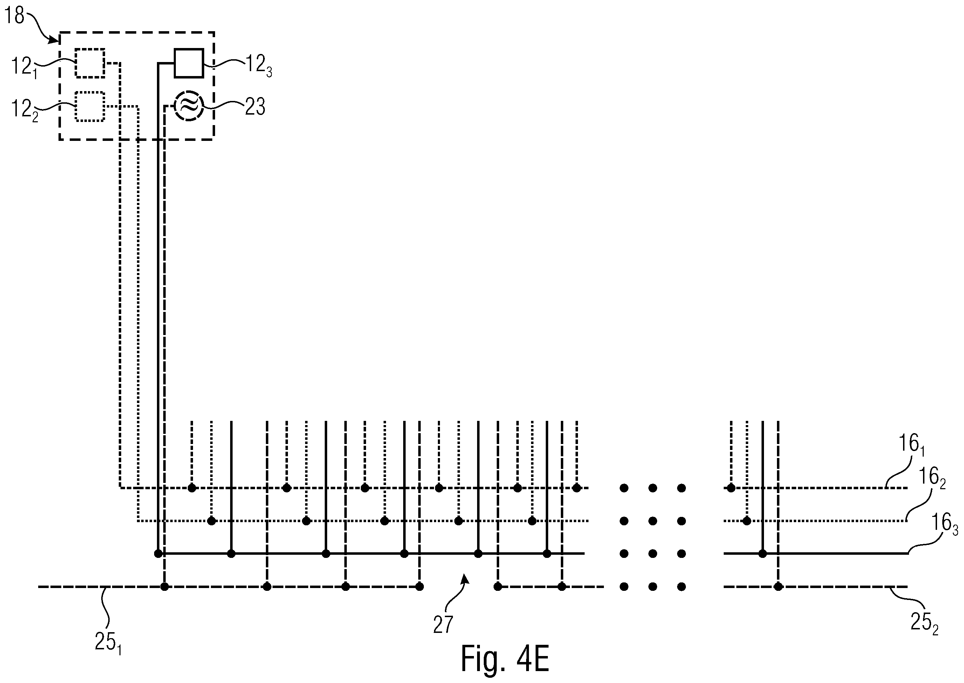

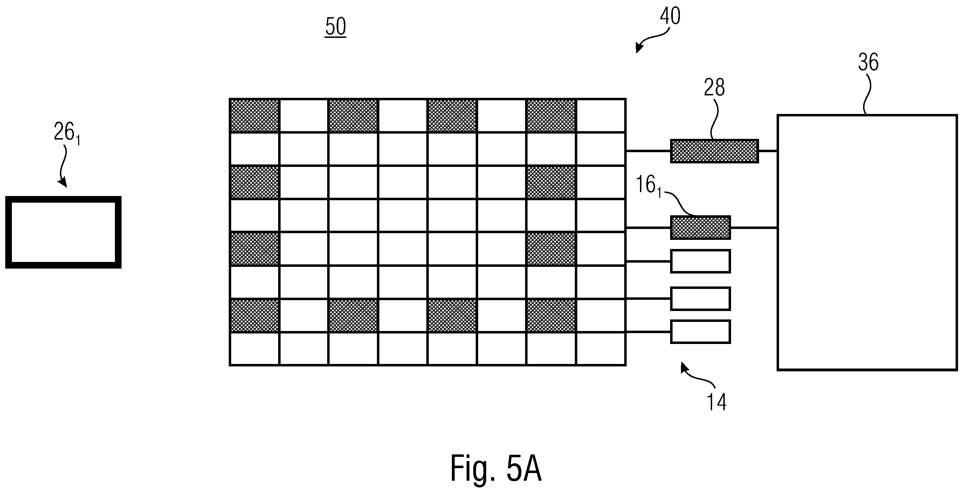

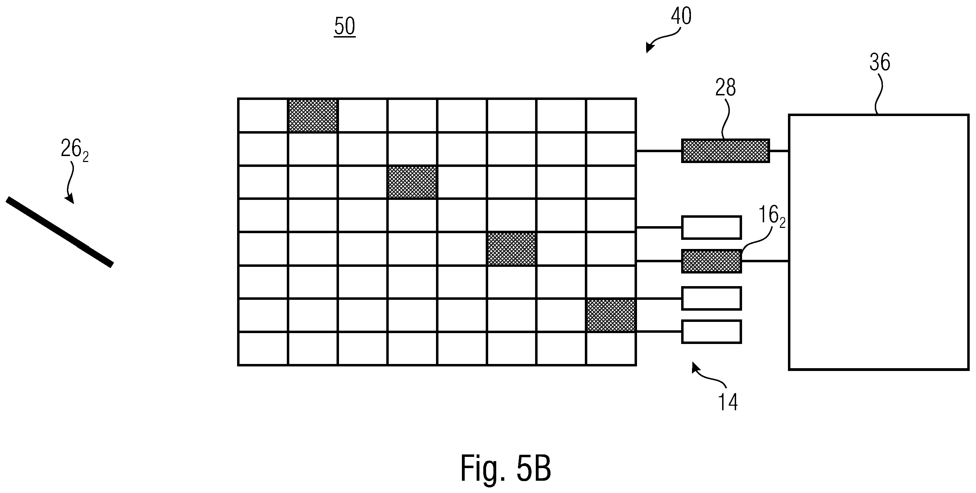

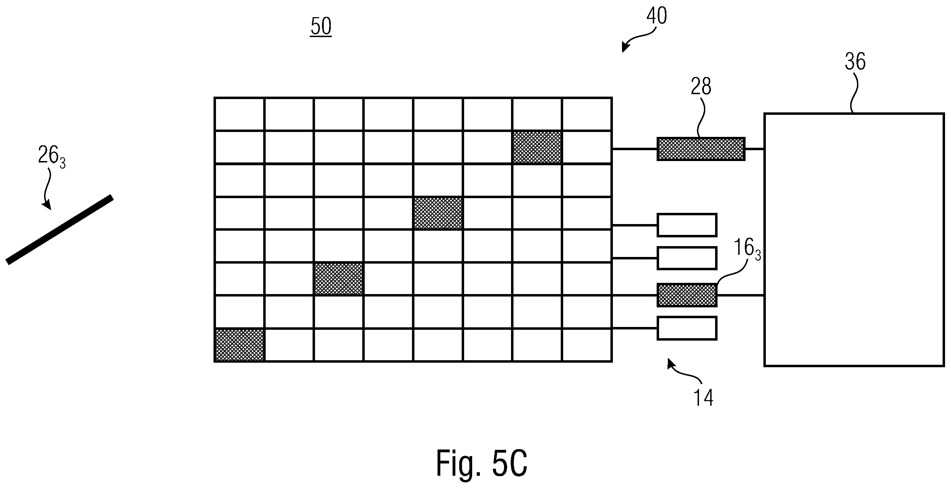

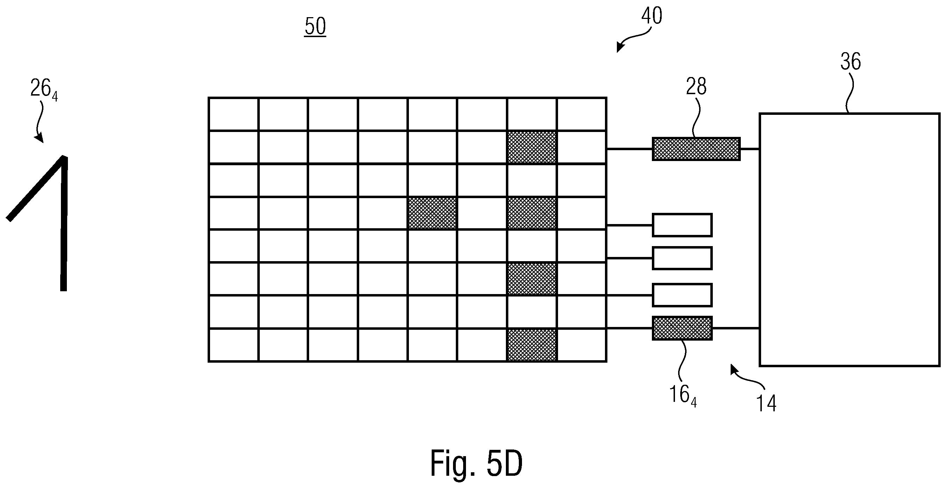

Kann man im Falle einfacher Informationswiedergabe und reduziertet Anforderungen an Variabilität und Flexibilität auf eine frei definierbare Ausgabe verzichten, so bieten sich direkt angesteuerte (direct drive) Leuchtelemente als Lösung an. Hierfür werden eine oder mehrere Leuchtflächen angesteuert, die entweder das Bildelement (Symbol) selbst ([1], Fig. 5) oder einen/mehrere Teile des Symbols ([1], Fig. 4) repräsentieren. Letzteres Element ist als 7-Segment-Anzeige z.B. zur Zeitanzeige (etwa bei einer Mikrowelle, einem digitalen LCD-Wecker, etc.) weit verbreitet und nutzt die Auswahl verschiedener Symbol-Kombinationen, um mit einem reduzierten Satz von Leuchtflächen (7) unterschiedliche Symbole (mindestens 0 - 9, zusätzlich Buchstaben, etc.) darzustellen. Gemeinsames Charakteristikum der direktgetriebenen Anzeigen ist, dass jede Leuchtfläche neben der Masseleitung genau eine Steuerleitung besitzt ([1], Fig. 4). Jedoch kann ein Leuchtelement nur in seiner Gänze aktiviert oder deaktiviert sein, so dass Symbole, wie in [1], Fig. 5 gezeigt, in der Regel nebeneinander platziert werden müssen.

Eine weitere Möglichkeit zur Darstellung von Symbolen mit wahlweisen Aktivierung oder Farbgebung stellen Schablonen dar, die beispielsweise in Tachometeranzeigen oder Tastern verbaut werden. Hier dient eine Schablone zur Definition der Leuchtfläche. Die Hintergrundbeleuchtung an/aus oder Farbe 1/Farbe 2/aus erlaubt eine kontextabhängige Wiedergabe von Informationen, siehe Fig. 8, die zur Darstellung einer oder mehrerer Symbole 1002₁ bis 1002₆ eingerichtet ist. In anderen Worten zeigt Fig. 8 eine hinterleuchtete Schablone in einer Bedieneinheit gemäß [3].

Während die eingangs genannten hochauflösenden Anzeigen komplexe Vorrichtungen sind, bieten Anzeigeeinrichtungen gemäß Fig. 8 vergleichsweise geringe Darstellungsmöglichkeiten, erfordern hierfür aber einen hohen Platzbedarf.

Wünschenswert wären demnach eine Anzeigeeinrichtung, ein Anzeigesystem, ein Multifunktionselement mit einem Anzeigesystem sowie ein Verfahren zum Bereitstellen einer Anzeigeeinrichtung, die es ermöglichen, ein vergleichsweise hohes Maß an Symbolen mit geringem Platzaufwand darzustellen und dabei den Komplexitätsgrad der Einrichtung gering zu halten.

Eine Aufgabe der vorliegenden Erfindung besteht deshalb darin, eine Anzeigeeinrichtung, ein Anzeigesystem, ein Multifunktionselement mit einem Anzeigesystem und ein Verfahren zum Bereitstellen einer Anzeigeeinrichtung bereitzustellen, welche ein Anzeigen mehrerer Symbole unter geringem Platzaufwand bei gleichzeitig geringem Komplexitätsgrad ermöglichen.

Diese Aufgabe wird durch den Gegenstand der unabhängigen Patentansprüche gelöst.

Ein Kerngedanke der vorliegenden Erfindung besteht darin, erkannt zu haben, dass es für die Wahrnehmung eines Symbols ausreichend sein kann, in einem Matrixdisplay lediglich vordefinierte Teilmengen, etwa Subpixel eines Pixels, zu verwenden und eine Gruppierung von Anzeigeelementen in disjunkte Teilmengen vorzunehmen, so dass mit den disjunkten Teilmengen einzelne Symbole ansteuerbar sind, was einfach möglich ist. Gleichzeitig kann basierend auf einer derartigen Gruppierung eine Verschachtelung der Anzeigeelemente vorgenommen werden, sollte dies erforderlich sein, so dass insgesamt eine hohe Menge an Symbolen platzsparend dargestellt werden kann und dies mit geringem Komplexitätsaufwand einhergeht.

Gemäß einem Ausführungsbeispiel umfasst eine Anzeigeeinrichtung eine Vielzahl von Anzeigeelementen und eine Verschaltungseinrichtung, die ausgebildet ist, um unterschiedliche und disjunkte Teilmengen der Anzeigeelemente miteinander zu verschalten. Anzeigeelemente einer Teilmenge sind vermittels der Verschaltungseinrichtung gemeinsam ansteuerbar.

Gemäß einem Ausführungsbeispiel umfasst ein Anzeigesystem eine derartige Anzeigeeinrichtung und eine Steuerungseinrichtung, die ausgebildet ist, um zumindest eine der Teilmengen der Anzeigeelemente als eine ausgewählte Teilmenge für eine Ansteuerung auszuwählen und um die zumindest eine ausgewählte Teilmenge vermittels der Verschaltungseinrichtung gemeinsam anzusteuern.

Gemäß einem weiteren Ausführungsbeispiel umfasst ein Multifunktionselement ein solches Anzeigesystem und ist ausgebildet, um abhängig von einem Betriebszustand des Systems, in welchem das Multifunktionselement eingesetzt wird, eine dem Betriebszustand zugeordnete Teilmenge von Anzeigeelementen anzusteuern, so dass die Anzeigeeinrichtung ein dem Betriebszustand zugeordnetes Muster darstellt.

Gemäß einem Ausführungsbeispiel umfasst ein Verfahren zum Herstellen einer Anzeigeeinrichtung ein Anordnen einer Vielzahl von Anzeigeelementen und ein Verschalten der Vielzahl von Anzeigeelementen in unterschiedliche und disjunkte Teilmengen, so dass Anzeigeelemente einer Teilmenge vermittels der Verschaltungseinrichtung gemeinsam ansteuerbar sind.

Weitere vorteilhafte Ausgestaltungen der vorliegenden Erfindung sind der Gegenstand abhängiger Patentansprüche.

Besonders bevorzugte Ausführungsformen der vorliegenden Erfindung werden nachfolgend Bezug nehmend auf die beiliegenden Zeichnungen erläutert. Es zeigen:
- Fig. 1a: eine schematische Draufsicht auf eine Anzeigeeinrichtung gemäß einem Ausführungsbeispiel;
- Fig. 1b-c: eine schematische Draufsicht und Seitenschnittansicht auf eine Verschaltung von Anzeigeelementen gemäß einem Ausführungsbeispiel;
- Fig. 2a: eine schematische Draufsicht auf eine Anzeigeeinrichtung gemäß einem Ausführungsbeispiel, die mehrere Pixel in einer regelmäßigen Anordnung von vier Zeilen und vier Spalten angeordnet sein können, umfasst;
- Fig. 2b: eine schematische vergrößerte Draufsicht auf ein Pixel der Anzeigeeinrichtung aus Fig. 2a;
- Fig. 3a: ein schematisches Blockschaltbild des Pixels gemäß Fig. 2b, wobei jedes Anzeigeelement gemäß einem Ausführungsbeispiel ein lichtemittierendes Element aufweist;
- Fig. 3b: ein schematisches Blockschaltbild eines gegenüber der Fig. 3a variierten Pixels gemäß einem Ausführungsbeispiel, bei dem neun Anzeigeelemente in einer 3x3-Anordnung als jeweilige Subpixel das Pixel bilden;
- Fig. 4a-d: schematische Darstellungen einer Anzeigeeinrichtung gemäß einem Ausführungsbeispiel sowie einer Gruppierung von Anzeigeelementen in unterschiedliche Teilmengen zur Darstellung vordefinierter Muster;
- Fig. 4e: eine schematische Darstellungen einer Verschaltung von Subpixeln eines Pixels;
- Fig. 5a-d: schematische Blockschaltbilder eines Anzeigesystems, das eine hierin beschriebene Anzeigeeinrichtung und eine Steuerungseinrichtung umfasst, gemäß einem Ausführungsbeispiel;
- Fig. 6a: ein schematisches Blockschaltbild eines Multifunktionselementes gemäß einem Ausführungsbeispiel in einem ersten Betriebszustand;
- Fig. 6b: ein schematisches Blockschaltbild des Multifunktionselementes aus Fig. 6a in einem anderen Betriebszustand;
- Fig. 7a: ein schematisches Ablaufdiagramm eines Verfahrens gemäß einem Ausführungsbeispiel;
- Fig. 7b: ein schematisches Ablaufdiagramm eines weiteren Verfahrens gemäß einem Ausführungsbeispiel; und
- Fig. 8: eine Ablichtung einer bekannten hinterleuchteten Schablone in einer Bedieneinheit.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Nachfolgend beschriebene Ausführungsbeispiele werden im Zusammenhang mit einer Vielzahl von Details beschrieben. Ausführungsbeispiele können jedoch auch ohne diese detaillierten Merkmale implementiert werden. Des Weiteren werden Ausführungsbeispiele der Verständlichkeit wegen unter Verwendung von Blockschaltbildern als Ersatz einer Detaildarstellung beschrieben. Ferner können Details und/oder Merkmale einzelner Ausführungsbeispiele ohne Weiteres mit einander kombiniert werden, solange es nicht explizit gegenteilig beschrieben ist.

Nachfolgende Ausführungsbeispiele werden unter Bezugnahme auf Terminologien, wie beispielsweise Pixel und Subpixel, beschrieben. Dabei kann ein Pixel bzw. Bildelement mehrere Subpixel umfassen, was beispielsweise in Matrix-basierten Displays eingesetzt wird. Ausgehend von einer Matrix-basierten Displaykonfiguration können Ausführungsbeispiele darauf bezogen sein, unterschiedliche Subpixel unterschiedlichen Mustern zuzuordnen bzw. unterschiedliche Subpixel eines Pixels für unterschiedliche Muster zu verwenden oder eines oder mehrere der Subpixel nicht zu verwenden bzw. dysfunktional zumindest für das Anzeigen auszugestalten, was eine Anordnung einer Sensoreinrichtung an dieser Stelle nicht ausschließt. Die Begrifflichkeiten Pixel und Subpixel sind dabei lediglich der besseren Anschaulichkeit der Ausführungsbeispiele gewählt und können ausgehend von bekannten Herstellungsprozessen Matrix-basierter Displays angewendet werden. Allerdings soll hierdurch der Gegenstand der vorliegenden Erfindung nicht auf eine derartige Konfiguration eingeschränkt werden.

Fig. 1a zeigt eine schematische Draufsicht auf eine Anzeigeeinrichtung 10 gemäß einem Ausführungsbeispiel. Die Anzeigeeinrichtung 10 weist eine Vielzahl von Anzeigeelementen 12₁ bis 12₂₀ auf.

Gemäß einem Ausführungsbeispiel sind die Vielzahl von Anzeigeelementen 12₁ bis 12₂₀ in einem regelmäßigen Array mit einer Mehrzahl an Spalten und einer Mehrzahl an Zeilen angeordnet. Die Anzeigeelemente 12₁ bis 12₂₀ können somit in einer Matrix-artigen Anordnung positioniert sein, wobei dies nicht erforderlich ist. Es kann insofern eine Anordnung in Form von Zeilen und Spalten umgesetzt werden, aber auch eine beliebige andere Form der Anordnung. Ferner können die Vielzahl von Anzeigeelementen 12₁ bis 12₂₀ hinsichtlich eines Flächenbereichs übereinstimmende Anzeigeelemente oder eine gruppenindividuelle Anzeigeoberflächengeometrie und/oder Flächeninhalte aufweisen. Anders ausgedrückt kann jedes der Anzeigeelemente 12₁ bis 12₂₀ hinsichtlich einer Form, einer Geometrie, eines Flächeninhalts, aber auch hinsichtlich anderer Eigenschaften, wie etwa einer Farbe, mit welcher Information angezeigt bzw. Licht ausgegeben wird und/oder einer Helligkeit individuell oder gruppenweise oder Anzeigeelemente global gleich ausgestaltet sein.

Die Anzeigeeinrichtung 10 umfasst ferner eine Verschaltungseinrichtung 14, die ausgebildet ist, um verschiedene und disjunkte Teilmengen der Anzeigeelemente miteinander zu verschalten. So können beispielsweise Anzeigeelemente 12₁, 12₇, 12₁₃ und 12₁₉ eine erste Gruppe von Anzeigeelementen bilden, die beispielsweise über ein Signal an einer Ansteuerleitung 16₁ gemeinsam ansteuerbar sind. Anders ausgedrückt sind in der vorliegenden Darstellung die Anzeigeelemente 12₁, 12₇, 12₁₃ sowie 12₁₉ fest miteinander verdrahtet und werden gemeinsam angesteuert, das heißt, sie sind gemeinsam aktiv oder inaktiv.

Eine hiervon disjunkte Teilmenge von Anzeigeelementen 12₃, 12₄, 12₅, 12₁₂ und 12₁₇ kann mit einer weiteren Ansteuerleitung 16₂ der Verschaltungseinrichtung 14 angesteuert werden, das heißt, die Anzeigeelemente 12₃, 12₄, 12₅, 12₁₂ und 12₁₇ sind fest miteinander verdrahtet und werden gemeinsam aktiviert oder deaktiviert.

Die Verschaltung in disjunkte Teilmengen ergibt, dass ein Anzeigeelement 12₁ bis 12₂₀ höchstens einer Teilmenge zugeordnet ist bzw. über höchstens eine Ansteuerleitung 16 ansteuerbar ist.

Es ist möglich, aber nicht erforderlich, dass jedes Anzeigeelement 12₁ bis 12₂₀ einer Teilmenge zugeordnet ist.

Gemäß einem Ausführungsbeispiel ist die Verschaltungseinrichtung 14 ausgebildet, um die Teilmengen der Anzeigeelemente unveränderlich miteinander zu verschalten, was auch als feste Verdrahtung bezeichnet werden kann.

Gemäß einem Ausführungsbeispiel ist jeder der Teilmengen 12₁, 12₇, 12₁₃ und12₁₉ einerseits und 12₃, 12₄, 12₅, 12₁₂ und 12₁₇ andererseits über einer der Teilgruppe eindeutig zugeordneten Ansteuerleitung 16₁ oder 16₂ eindeutig ansteuerbar.

An dieser Stelle sei darauf hingewiesen, dass die Position und/oder Anzahl der Anzeigeelemente einer Teilgruppe sowie die Anzahl von Teilgruppen ebenso wie die Anzahl von Anzeigeelementen in der Anzeigeeinrichtung 10 beliebig ausgestaltet werden kann. So ist die Anzahl von Anzeigeelementen bevorzugt zumindest drei, zumindest fünf, zumindest zehn, größer als 100, größer als 1000 oder noch größer. Die Anzahl von Anzeigeelementen je Teilgruppe beträgt zumindest zwei, ist aber bevorzugt größer, etwa zumindest zehn, zumindest 20 oder zumindest 100. Die Anzahl von Teilgruppen kann der Anzahl von zwei entsprechen, kann aber bevorzugt auch größer ausgebildet sein, beispielsweise zumindest drei, zumindest fünf, zumindest zehn oder zumindest 20.

In einer vorteilhaften Ausgestaltung ist jede der Teilmengen einem mit der Anzeigeeinrichtung 10 darzustellenden vordefinierten Muster eindeutig assoziiert bzw. jede der Teilmengen ist einem mit der Anzeigeeinrichtung darzustellenden vordefinierten Muster eindeutig zugeordnet. Die Anzeigeeinrichtung 10 kann ausgebildet, um das der Teilmenge zugeordnete vordefinierte Muster vermittels der gemeinsamen Ansteuerung der Anzeigeelemente darzustellen. Das bedeutet, ein darzustellendes Muster kann über die Adressierung der der Teilmenge von Anzeigeelementen 12₁ bis 12₂₀ zugeordneten Ansteuerleitung 16₁ oder 16₂ dargestellt werden. Es ist aber möglich, insbesondere bei Verwendung einer höheren Anzahl von Teilmengen und einer höheren Anzahl von Ansteuerleitungen 16, ein kombinatorisches Muster durch Ansteuern mehrerer der Ansteuerleitungen 16 mit der Anzeigeeinrichtung 10 auszugeben.

Im Zusammenhang mit manchen der hierin beschriebenen Ausführungsbeispielen wird Bezug genommen auf Subpixel, die Teile eines Pixels bilden, wobei Subpixel unterschiedlicher Pixel zu einer Teilmenge von Subpixeln verschaltet werden können, welche basierend auf der Verschaltung wiederrum gemeinschaftlich angesteuert werden können. Der Begriff der Verschaltung für die Aktivierung eines Subpixels kann so verstanden werden, dass im Wesentlichen eine Anbindung des Subpixels mittels einer Leiterbahn erfolgt. Fig. 1b und Fig. 1c zeigen eine schematische Draufsicht bzw. eine schematische Seitenschnittansicht einer im Rahmend der Ausführungsbeispiele möglichen aber nicht notwendigen Ausgestaltung der Verschaltung.

Zwischen einer ersten Elektrode 32, etwa einer Anode, und einer zweiten Elektrode 34, etwa einer Kathode, kann ein lichtemittierendes Element oder Leuchtelement 24 angeordnet sein. Das lichtemittierende Element 24 kann im Bereich einer Öffnung oder Aussparung 17 eines Isolators 19 elektrisch mit der Elektrode 32 kontaktiert sein. Eine Subbpixelanbindung 21 kann als elektrische Leitung eine elektrische Verbindung mit einer für die Gruppe bzw. Teilmenge gemeinsamen Ansteuerleitung 16 herstellen, wobei die Ansteuerleitung 16 und die Subpixelanbindung aus demselben Material oder unterschiedlichen Materialien und/oder aus einem oder mehreren Strukturen oder Stücken bestehen können.

Es existieren eine Vielzahl von Möglichkeiten, die Aktivierung des Subpixels bzw. der Gruppe von Anzeigeelementen vorzunehmen.

In einer mögliche Ausgestaltung ist jedes Subpixel eindeutig einer der disjunkten SubpixelGruppen zugehörig oder zugeordnet, welche über die Steuerleitung 16 ausgewählt wird.

Die Entscheidung, ob ein Pixel leuchtet oder nicht erfolgt im Rahmen vorteilhafter Ausgestaltungen möglicherweise
- über die Verschaltung oder Anordnung bzw. Ausführen oder nicht Ausführen der Subpixel-Anbindung (21),
- über Ersatz der Anbindung (21) durch ein programmierbares Element, etwa ein resistives Element,
- über Ausführen oder nicht Ausführen der Elektrode 32 am Ort des Subpixels, etwa dahingehend dass manche Bereiche bei Fehlen der Elektrode funktionsunfähig hinsichtlich der Lichtemission sind
- über Ausführen oder nicht Ausführen der Öffnung 17 in der Isolationsschicht, etwa bei einer Ausgestaltung der Anzeigeeinrichtung als OLED-Anzeige, etwa dahingehend dass manche Bereiche bei Fehlen der Öffnung funktionsunfähig hinsichtlich der Lichtemission sind;
- über Ausführen oder nicht Ausführen des Leuchtelements 24, etwa bei einer Ausgestaltung als µLED-Anzeige, etwa dahingehend dass manche Bereiche bei Fehlen des Leuchtelements funktionsunfähig hinsichtlich der Lichtemission sind; und/oder
- das Anbringen eines optisch dichten Helligkeitsfilters über dem Subpixel, d. h., an einer der Elektrode 32 abgewandten Seite des Leuchtelements 24 auf welcher sich in der Regel der Betrachter befindet, so dass das Element möglicherweise zwar leuchtet aber nicht abstrahlt.

Jeder dieser Mechanismen kann im Rahmen der Ausführungsbeispiele als Verschalten verstanden oder subsummiert werden, so dass die Subpixel-Anbindung 21 eine mögliche aber nicht notwendige Implementierung ist.

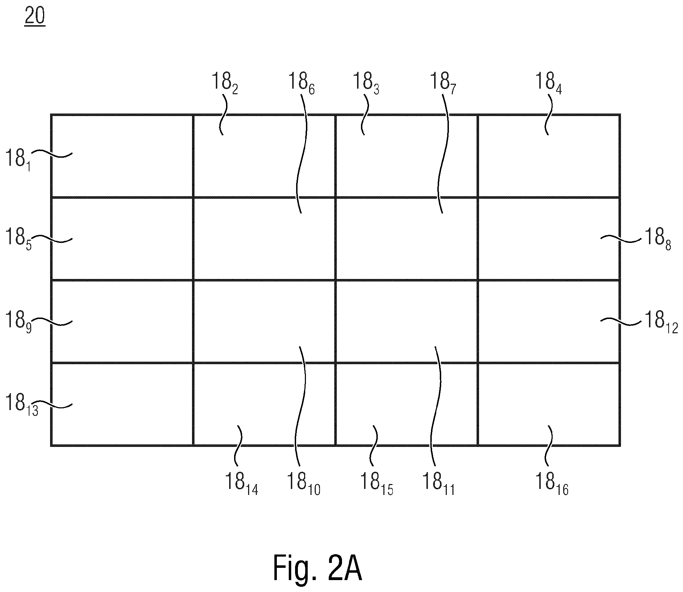

Fig. 2a zeigt eine schematische Draufsicht auf eine Anzeigeeinrichtung 20 gemäß einem Ausführungsbeispiel. Diese umfasst beispielhaft Pixel 18₁ bis 18₁₆, die in einer regelmäßigen Anordnung von vier Zeilen und vier Spalten angeordnet sein können, wobei sowohl die Anzahl der Pixel als auch die Anzahl von Spalten als auch die Anzahl von Zeilen lediglich beispielhaft gewählt ist und andere, insbesondere größere Werte aufweisen kann.

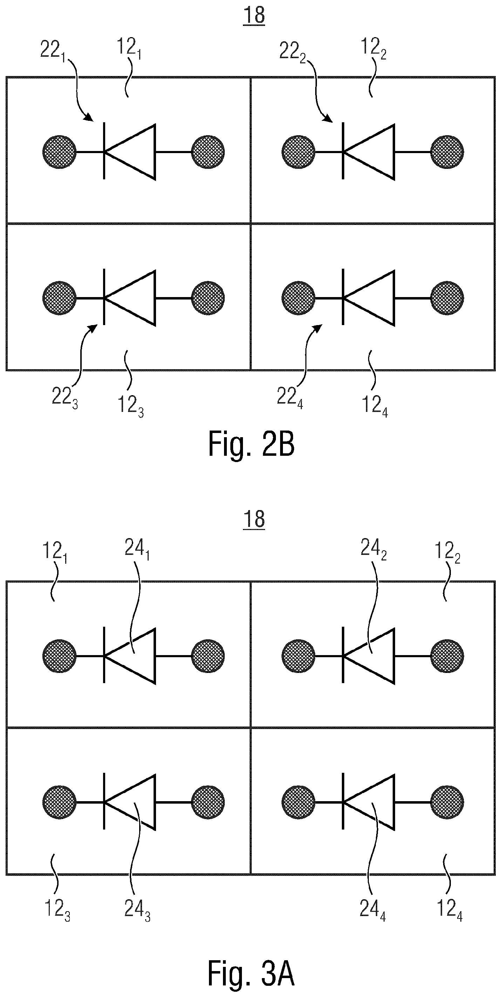

Fig. 2b zeigt eine schematische Draufsicht auf ein Pixel 18 der Anzeigeeinrichtung 20. Das Pixel 18 weist beispielhaft vier Anzeigeelemente 12₁ bis 12₄ auf, die in einer 2x2-Anordnung mit zwei Spalten und zwei Zeilen angeordnet sein können, wobei auch hier die Anzahl der Spalten, die Anzahl der Zeilen und/oder die Anzahl der Anzeigeelemente anders ausgeführt sein kann, beispielsweise lediglich eine Zeile oder alternativ lediglich eine Spalte oder mehr als zwei Zeilen und/oder mehr als zwei Spalten. Vermittels von Diodensymbolen 22₁ bis 22₄ ist dargestellt, dass jedes der Anzeigeelemente 12₁ bis 12₄ einzeln ansteuerbar ist und ansprechend auf ein beispielsweise elektrisches Signal eine optische Information ausgeben kann bzw. Licht emittieren kann, wozu sich beispielsweise aber nicht ausschließlich lichtemittierende Dioden, LEDs, eignen können. Bei Betrachtung oder Zuordnung der Anzeigeelemente 12₁ bis 12₄ als ein Pixel können die Anzeigeelemente 12₁ bis 12₄ als Subpixel des Pixels betrachtet werden. Beispielsweise kann jedes der Subpixel 12₁-12₄ zumindest ein lichtemittierendes Element, etwa eine lichtemittierende Diode, LED, umfassen.

In der Zusammenschau mit der Fig. 2a wird deutlich, dass die einzelnen Pixel 18₁ bis 18₁₆ mit einer Verschaltungseinrichtung 14 der Anzeigeeinrichtung 10 unterschiedlich für unterschiedliche Symbole genutzt werden können und dass auf einfache Art und Weise die unterschiedlichen Symbole auf einem Display bzw. einer Anzeigeeinrichtung darstellbar sein können, indem für jedes Symbol lediglich eine Ansteuerleitung 16₁/16₂ gegebenenfalls in Kombination mit einer individuellen oder kombinierten Rückleitung verwendet wird.

Fig. 3a zeigt ein schematisches Blockschaltbild des Pixels 18 gemäß Fig. 2b, wobei jedes Anzeigeelement bzw. Subpixel 12₁-12₄ ein lichtemittierendes Element 24₁-24₄ aufweist. Zusätzliche, beispielsweise in Serie oder parallel geschaltete, lichtemittierende Elemente, beispielsweise zur Darstellung einer Farbmischung oder zur Erhöhung der Helligkeit, sind gemäß Ausführungsbeispielen nicht ausgeschlossen.

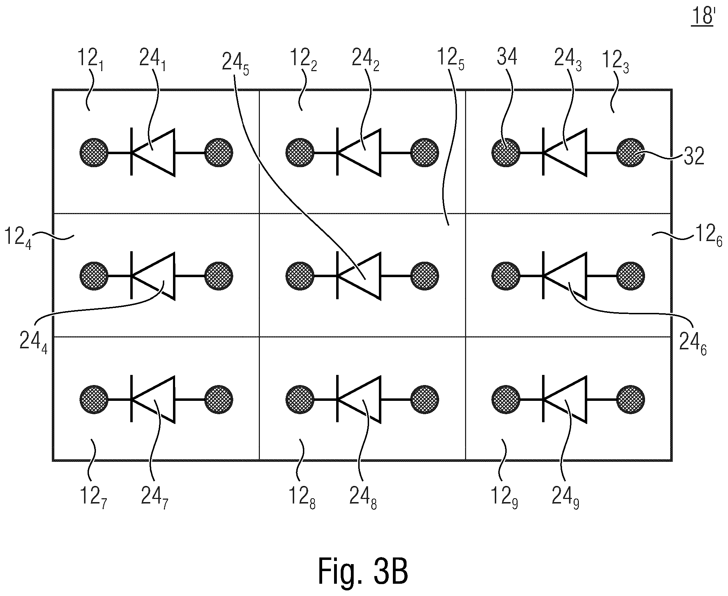

Fig. 3b zeigt ein schematisches Blockschaltbild eines gegenüber der Fig. 3a variierten Pixels 18', bei dem neun Anzeigeelemente 12₁-12₉ in einer 3x3-Anordnung als jeweilige Subpixel das Pixel 18' bilden. Eine andere Anzahl von Zeilen und/oder eine andere Anzahl von Spalten sowie eine von einer Matrixanordnung variierende Anordnung sind gemäß Ausführungsbeispielen nicht ausgeschlossen.

Fig. 4a zeigt eine schematische Darstellung einer Anzeigeeinrichtung 40 gemäß einem Ausführungsbeispiel, die beispielhaft 16 Pixel 18₁-18₁₆ mit einer jeweiligen Konfiguration der Pixel gemäß den Fig. 2b und 3a umfasst. Die Anzahl der Pixel ist dabei lediglich beispielhaft gewählt und kann insbesondere deutlich größer sein. Jedes der Pixel 18₁-18₁₆ umfasst Anzeigeelemente 12i,j, wobei der Parameter i das Pixel des Anzeigeelements angibt und der Parameter j eine laufende Nummer innerhalb des Pixels 18 beschreibt.

Die Anzeigeeinrichtung 40 kann ausgebildet sein, um beispielhaft und unter Verwendung der Anzeigeelemente 12_{i,j} vier Muster 26₁, 26₂, 26₃ und 26₄ darzustellen, wobei die Muster 26₁-26₄ lediglich exemplarisch und nicht einschränkend gewählt sind, um die Vorteile der vorliegenden Erfindung weiter zu verdeutlichen.

Beispielsweise können die Anzeigeelemente 12_{i,1} der Anzeigeeinrichtung 40 zu einer ersten Teilmenge miteinander verschaltet sein, die über eine erste Ansteuerleitung 16₁ ansteuerbar ist, um beispielsweise beim Betrachter ein Rechteck-Muster oder quadratisches Muster 26₁ wahrnehmbar zu machen. Eine gemeinsame Rückleitung 28 der Teilmengen, welche durch die Ansteuerleitungen 16₁, 16₂, 16₃ bzw. 16₄ ansteuerbar sein können, kann zur Darstellung mehrerer oder gar aller Muster 26₁-26₄ kontaktiert werden.

Während für das Muster 26₁ beispielsweise sämtliche Anzeigeelemente 12_{i,1} mit der Verschaltungseinrichtung 14 kontaktiert werden können und durch die Ansteuerleitung 16₁ angesteuert werden können, kann für andere Muster, etwa das Muster 26₂ lediglich ein Anzeigeelement 12i,j einer Teilmenge der Pixel kontaktiert werden. So können beispielsweise die Anzeigeelemente 12i,2 der Pixel 18₁, 18₆, 18₁₁ und 18₁₆ zu einer zweiten Teilmenge verschaltet sein, welche beispielsweise über die Ansteuerleitung 16₂ ansteuerbar ist, um einen diagonalen Strich des Musters 26₂ darzustellen.

Fig. 4c zeigt eine Verschaltung von Anzeigeelementen 12_{i,3} der Pixel 18₄, 18₇, 18₁₀ und 18₁₃, welche gemeinschaftlich über die Ansteuerleitung 16₃ ansteuerbar sind, um einen ebenfalls diagonalen Strich als Muster 26₃ bei einem Betrachter wahrnehmbar zu machen. Das Muster 26₃ ist beispielhaft gegenüber dem Muster 26₂ geneigt, etwa um 90 Grad aufgrund der Anordnung der Anzeigeelemente.

Gemäß Ausführungsbeispielen kann eine Ansteuereinrichtung zu einem Zeitpunkt lediglich eine der Ansteuerleitungen 16₁-16₄ oder keine der Ansteuerleitungen 16₁-16₄ ansteuern. Gemäß einer weiteren Ausführungsform ist eine Steuerungseinrichtung ausgebildet, um zu einem Zeitpunkt mehrere der Ansteuerleitungen 16₁-16₄ anzusteuern. So könnte beispielsweise durch gemeinschaftliches Ansteuern der Ansteuerleitungen 16₂ und 16₃ ein x-Muster beim Betrachter darstellbar sein.

Fig. 4 zeigt eine Verschaltung einer weiteren, vierten Teilmenge von Anzeigeelementen, bei der die Anzeigeelemente 12i,4 der Pixel 18₃, 18₆, 18₇, 18₁₁ und 18₁₅ miteinander verschaltet sind, um bei Ansteuerung über die gemeinschaftliche Ansteuerleitung 16₄ das Muster 26₄, etwa eine "1" beim Betrachter darzustellen.

Es zeigt sich, dass Pixel jeweils ein Teil mehrerer darstellbarer Muster sein können, etwa das Pixel 18₃ für die Muster 26₁ und 26₄, das Pixel 18₆ für die Muster 26₂ und 26₄ oder das Pixel 18₁₁ für die Muster 26₂ und 26₄. Für die jeweils unterschiedlichen Muster können voneinander verschiedene Anzeigeelemente 12 eines Pixels 18 über die Ansteuerung mit unterschiedlichen Ansteuerleitungen 16₁-16₄ aktiviert werden.

Je kleiner das jeweilige Anzeigeelement 26₁-26₄ ausgestaltet wird, desto näher kann der Betrachter der Anzeigeeinrichtung kommen und gleichzeitig die Muster 26₁-26₄ in guter Qualität wahrnehmen. Qualitätseinbußen können dahingehend akzeptiert werden, etwa indem dennoch zuverlässig Information wiedergegeben wird. Eine Leuchtfläche eines Anzeigeelements kann beliebig gewählt werden und kann bei bevorzugten Ausführungsformen beispielsweise eine Größe in einem Bereich von 50-100 µm² aufweisen. So kann beispielsweise als Anzeigeelement eine Mikro-LED (µLED) verwendet werden, die eine Kantenlänge der lichtemittierenden Fläche in einem Bereich von etwa 10 µm aufweisen kann. Aussagekräftiger für ein Display ist jedoch die Dichte von Anzeigepunkten, die in Ausführungsbeispielen zumindest 300 dpi (Punkte/Dots pro inch/Zoll), zumindest 400 dpi oder zumindest 500 dpi betragen kann.

Eine Zuordnung von vier Anzeigeelementen 12 zu einem Pixel 18 in Kombination mit einer Darstellungsmöglichkeit von vier Mustern 26₁-26₄ mit der Anzeigeeinrichtung 40 ist dabei jedoch lediglich beispielhaft gewählt und nicht einschränkend. Die Anzeigeeinrichtung 40 könnte im Weiteren ausgebildet sein, um zumindest ein fünftes Muster darzustellen, etwa einen senkrechten Strich, beispielsweise in der zweiten Spalte der Anzeigeeinrichtung, da sowohl das Pixel 18₂ als auch die Pixel 18₆, 18₁₀ und 18₁₃ Anzeigeelemente umfassen, die noch keinem der Muster 26₁-26₄ zugeordnet sind.

Es ist ferner anzumerken, dass eine feste Zuordnung einer Anzeigeelementeposition innerhalb eines Pixels zu einem speziellen Muster beispielhaft und für die Produktion auch einfach und damit vorteilhaft sein kann, aber durchaus auch von einer derartigen Konfiguration abgewichen werden kann. So könnte beispielsweise für das Muster 26₄ ohne weiteres das Anzeigeelement 12_{15,2} anstelle des Anzeigeelements 12_{15,4} genutzt werden. Ähnlich können andere Anzeigeelemente beliebig zu Mustern zugeordnet werden, wobei es bevorzugt ist, dass ein Anzeigeelement lediglich einer Teilmenge zugeordnet ist, welche jeweils über eine Ansteuerleitung 16₁-16₄ angesteuert wird und dass die Teilmenge von Anzeigeelementen untereinander disjunkt sind.

Anhand der Anzeigeeinrichtung 40 werden weitere vorteilhafte Ausgestaltungen erläutert. Gemäß einem Ausführungsbeispiel wird eine Anzeigeeinrichtung bereitgestellt, bei der ein erstes Farbfilter bezüglich einer, mehrerer oder aller Anzeigeelemente einer ersten Teilmenge von Anzeigeelemente angeordnet ist. Dies kann für eine Farbgebung oder Farbmanipulation zumindest eines der Muster 26₁-26₄ genutzt werden. Optional kann ein zweites Farbfilter bezüglich Anzeigeelementen einer zweiten Teilmenge von Anzeigeelementen angeordnet sein. Eines oder mehrere der verwendeten Farbfilter kann dabei steuerbar sein, etwa hinsichtlich der Transmissionswellenlänge, des Transmissionsgrades und/oder einem Betriebszustand, etwa an/aus. So kann beispielsweise eine Ausgestaltung der Anzeigeeinrichtung 40 dergestalt vorliegen, dass eines der Muster 26₁-26₄ mehrfach darstellbar ist und jede der Darstellungen mit einem unterschiedlichen Farbfilter kombiniert wird.

Gemäß einem Ausführungsbeispiel wird von einer derartigen Konfiguration dahingehend abgewichen, dass zumindest ein Farbfilter vorgesehen ist, das bezüglich zumindest eines Anzeigeelements und entgegengesetzt zu einer Betrachtungsrichtung der Anzeigeeinrichtung angeordnet ist, das heißt, zwischen dem lichtemittierenden Element und dem Betrachter. Das Farbfilter kann ausgebildet sein, um ein von dem Anzeigeelement bereitgestelltes Licht zu filtern.

Gemäß einem weiteren Ausführungsbeispiel ist die Anzeigeeinrichtung dergestalt ausgestaltet, dass die Anzeigeelemente einer Teilmenge eine gemeinsame Kontaktierung aufweisen, etwa die Ansteuerleitungen 16₁, 16₂, 16₃ oder 16₄. Bei einer Beschaltung der gemeinsamen Kontaktierung ist entweder keines der Anzeigeelemente der Teilmenge aktiviert oder alle Anzeigeelemente der Teilmenge aktiviert.

Dabei können beispielsweise die Ansteuerleitungen 16₁-16₄ eines der Hinleitung und der Rückleitung der jeweiligen Teilmenge bereitstellen und das verbleibende Element, beispielsweise die Rückleitung oder alternativ die Hinleitung, kann für unterschiedliche Teilmengen oder gar alle Teilmengen kombiniert werden, etwa in der Rückleitung 28, da hierdurch immer noch eine gruppenweise individuelle Ansteuerung ermöglicht wird.

Gemäß einem Ausführungsbeispiel wird eine Anzeigeeinrichtung bereitgestellt, bei der jedes Anzeigeelement einen ersten elektrischen Anschluss und einen zweiten elektrischen Anschluss aufweist. Unter Verweis auf die Fig. 3b kann dies beispielsweise eine Anode 32 einer Diode/LED sein. Als zweiter Anschluss kann korrespondierend hierzu eine Kathode 34 angeordnet sein bzw. ein Kathodenanschluss. Für andere Elemente können andere Bezeichnungen elektrischer Anschlüsse oder elektrischer Pole verwendet werden. Gemäß dem Ausführungsbeispiel können erste Anschlüsse unterschiedlicher Anzeigeelemente einer Teilmenge der Anzeigeelemente vermittels der Verschaltungseinrichtung 14 miteinander verschaltet und von ersten Anschlüssen von Anzeigeelementen anderer Teilgruppen elektrisch getrennt sein. Zweite Anschlüsse, etwa die Kathodenanschlüsse 34 von Anzeigeelementen unterschiedlicher Teilmengen können vermittels der Verschaltungseinrichtung 14 miteinander verschaltet sein, etwa kontaktierbar über die gemeinsame Rückleitung 28 in Fig. 4a-d.

Gemäß einem Ausführungsbeispiel ist die Vielzahl von Anzeigeelementen eine Vielzahl von Subpixeln, die in eine geringere Vielzahl von Pixeln gruppiert ist. Bevorzugt ist, dass jedes Subpixel höchstens einer Gruppe/Teilmenge zugehörig ist. Jede Teilmenge von Anzeigeelementen weist bevorzugt höchstens ein Subpixel eines Pixels auf. Das bedeutet, jede Teilmenge von Anzeigeelementen weist in einem Pixel entweder kein Subpixel oder genau ein Subpixel auf.

Gemäß einem Ausführungsbeispiel ist die Anzeigeeinrichtung so ausgestaltet, dass bei einer Ansteuerung unterschiedlicher Teilmengen der Anzeigeelemente unterschiedliche Subpixel eines Pixels angesteuert werden, etwa die Anzeigeelemente 12_{1,1} und 12_{1,2} bei gemeinschaftlicher Ansteuerung der Ansteuerleitungen 16₁ und 16₂ zum Darstellen der Muster 26₁ und 26₂.

Für eine einfache Herstellung der Anzeigeeinrichtung kann es von Vorteil sein, dass jedes Pixel der Anzeigeeinrichtung eine übereinstimmende Anzahl von Subpixeln aufweist. In der Anzeigeeinrichtung 40 sind dies beispielhaft vier Pixel, im Pixel 18' der Fig. 3b beispielhaft neun. Wie es bereits erörtert wurde, kann von einer derartigen Anzahl abgewichen werden und die Anzahl von Zeilen und/oder Spalten kann beliebig gewählt werden.

Gemäß einem Ausführungsbeispiel ist die Vielzahl von Anzeigeelementen einer Anzeigeeinrichtung für eine Bereitstellung einer übereinstimmenden, einer gruppenweise übereinstimmenden oder einer individuellen Anzeigehelligkeit ausgebildet. Dies kann beispielsweise in Abhängigkeit des darzustellenden Musters gewählt werden. Alternativ oder zusätzlich hierzu kann ein resistives Element eingesetzt werden, das beispielsweise ein Teil der Versorgungsleitung oder Ansteuerleitung 16₁-16₄ ist oder seriell hierzu geschaltet ist und so im Schaltkreis zumindest einer der Teilmengen von Anzeigeelementen verschaltet ist. Unter Verwendung des resistiven Elements kann eine Helligkeit der Anzeigeelemente eingestellt werden, wobei mit zunehmendem ohmschen Widerstand die Helligkeit beispielsweise abnehmen kann. Gemäß einer besonders bevorzugten Ausführungsform ist das resistive Element ein steuerbares Element, insbesondere in programmierbares resistives Element. Dieses kann beispielsweise von einer Steuerungseinrichtung angesteuert werden, um nebst dem dargestellten Muster auch die Helligkeit der Darstellung einzustellen.

Gemäß einem Ausführungsbeispiel umfasst eine Anzeigeeinrichtung ein Helligkeitsdämpfungselement, das bezüglich zumindest einem der Anzeigeelemente entgegengesetzt zu einer Betrachtungsrichtung angeordnet ist und ausgebildet ist, um eine von dem Anzeigeelement bereitgestellte Helligkeit entgegengesetzt zu der Betrachtungsrichtung zu dämpfen, das heißt, die Helligkeit, die vom Betrachter wahrgenommen wird. Gemäß einer besonders bevorzugten Ausführungsform ist das Helligkeitsdämpfungselement bezüglich eines Dämpfungsgrades, mit welchem die Helligkeit des Anzeigeelements gedämpft wird, steuerbar, etwa von einer mit der Anzeigeeinrichtung gekoppelten Steuerungseinrichtung.

Unter Bezugnahme auf die Fig. 4a-d wird eine weitere vorteilhafte Ausgestaltung erörtert. Eine Anzeigeeinrichtung gemäß einem Ausführungsbeispiel kann zumindest ein Sensorelement, bevorzugt eine Vielzahl von Sensorelementen, umfassen, beispielsweise ein Photodetektorelement, wobei das Sensorelement exakt einer Teilmenge von Anzeigeelementen zugeordnet ist. Bei Verwendung einer Vielzahl von Sensorelementen kann jedes der Sensorelemente exakt einer Teilmenge von Anzeigeelementen zugeordnet sein, wobei eine Teilmenge von Anzeigeelementen kein, ein oder mehrere Sensorelemente umfassen kann. Verwendete Sensorelemente können dabei von gleicher Art oder auch verschiedenartig sein. Eine Art von Sensorelementen kann beispielsweise ein Fotodetektorelement sein. Alternativ oder zusätzlich können auch näherungsempfindliche oder berührungsempfindliche Sensorelemente eingesetzt werden, etwa kapazitive Sensoren, etwa Touch-Sensoren. Diese können für eine Auswertung/Auslesung genutzt werden, etwa für eine Gestensteuerung. Eine Verwendung derartiger Elemente kann auf unterschiedliche Weise erfolgen. So kann beispielsweise eine Unterscheidung von einer Auswerteeinrichtung oder Steuerungseinrichtung getroffen werden, ob ein Gegenstand oder ein Nutzer sich in einem bestimmten Bereich des Displays aufhält, etwa vor der linken Hälfte oder der rechten Hälfte. Alternativ können auch Kamera-Funktionalitäten oder dergleichen umgesetzt werden.

Alternativ oder zusätzlich kann auch eine Helligkeitssteuerung oder Helligkeitsregelung umgesetzt werden, etwa unter Bereitstellung zusätzlicher ggf. steuerbarer Helligkeitsquellen. Diese können bspw. umfassend LCD-Pixel umgesetzt werden. Alternativ oder zusätzlich kann eine Detektion einer Umgebungshelligkeit erfolgen, etwa zur Steuerung der Leuchtstärke.

Obwohl es im Sinne des Herstellungsprozesses bevorzugt ist, Pixel 18 gleich auszubilden und hinsichtlich der Verschaltung zu variieren bzw. unterschiedlichen Teilmengen zuzuordnen, können unterschiedliche Pixel auch unterschiedlich hinsichtlich der Anzeigeelemente und/oder der Anordnung von Sensorelementen und/oder der Art von Sensorelementen.

In Fig. 4e ist eine schematische Darstellung einer Verschaltung von Pixeln dargestellt, wobei zur besseren Übersicht lediglich ein Pixel 18 dargestellt ist, welches der Anzeigeelemente 12₁ bis 12₃ oder eine andere Anzahl hiervon aufweisen kann und ferner in einem mehreren oder jedem Pixel ein Sensorelement 23 angeordnet ist, welches über eine Steuerleitung 25 ähnlich der Ansteuerleitungen 16₁ bis 16₃ adressierbar sein kann. Um unterschiedliche Teilbereiche der Anzeigeeinrichtung unterschiedlich anzusteuern kann zumindest eine Unterbrechung 27 der Steuerleitung 25 vorgesehen sein um zwei oder mehrere Segmente 25₁ und 25₂ zu erzeugen, die dann individuell kontaktierbar sind. Da die Sensorik z. B. wie dargestellt auf jedem vierten Subpixel eines Pixels, d.h. innerhalb einer disjunkten Gruppe untergebracht sein kann, kann diese zunächst einen klar abgegrenzten Anschluss aufweisen, etwa über die Leitung 25. Eine Ortsauflösung kann bspw. erreicht werden, indem unterschiedliche Subpixelgruppen, etwa die der linken Bildhälfte und die der rechten Bildhälfte separat zusammenfasst bzw. entsprechend feiner auflöst. Sensorelemente 23 unterschiedlicher Pixel können in eine aus zumindest einer oder auch mehreren Gruppen von Sensorelementen zusammengeschaltet sein.

Unter Bezugnahme auf die Anzeigeeinrichtung 40 können beispielsweise Orte der Anzeigeeinrichtung, an denen kein Anzeigeelement für eines der Muster 26₁ bis 26₄ benötigt wird, durch ein Sensorelement ersetzt werden, etwa ein Ort des Anzeigeelementes 12_{1,4}. Ein derartiges Sensorelement kann dabei auch eine geringere Größe als es in der Rasteranordnung verfügbar wäre als Bauraum verwenden. Gemäß einem Ausführungsbeispiel zur Verwendung von Sensorelementen kann beispielsweise ein Quadrant, zwei Quadranten oder drei Quadranten einer 2x2-Anordnung eines Pixels, wie sie bspw. in Fig. 3a dargestellt ist, mit Anzeigeelementen bestückt sein und zumindest ein Quadrant mit einem Sensorelement. Andere Anordnungen, etwa eine Anordnung gemäß Fig. 3b oder andere ermöglichen zusätzliche Möglichkeiten der Umsetzung ebenso wie eine Anordnung von Anzeigeelementen in einer von einer Matrix-Anordnung abweichenden Anordnung.

Gemäß einem Ausführungsbeispiel können alternativ zu einer Verwendung des Bauraums eines ungenutzten Anzeigeelementes für ein Sensorelement die entsprechenden Bereiche oder Oberflächenbereiche der Anzeigeeinrichtung 40 auch anderweitig unbrauchbar gemacht werden, was eine hohe Fehlerunanfälligkeit bereitstellt. Gemäß einem solchen Ausführungsbeispiel wird eine Anzeigeeinrichtung mit zumindest einem Teilbereich einer Anordnung, etwa einer Matrixanordnung, der Anzeigeelemente bereitgestellt, der einem Anzeigeelement in der Anordnung zugeordnet ist und hinsichtlich einer Funktion zum Anzeigen funktionsunfähig gebildet ist. Das bedeutet, die Vielzahl von Anzeigeelementen innerhalb einer Gruppe, die nicht aktiviert sind, können reale, das heißt, hergestellte Anzeigeelemente sein, die nicht durch eine Ansteuerleitung angeschlossen oder kontaktiert sind. Alternativ hierzu ist es möglich, dass derartige Anzeigeelemente zwar angeschlossen sind, aber konstruktiv, etwa durch bewusstes Weglassen einer Öffnung durch eine Isolationsschicht oder dergleichen als nicht funktionsfähig prozessiert werden. Dies kann dazu führen, dass es zwar Pixel/Subpixel bzw. Flächen auf dem Display gibt, bei denen aufgrund der Ausführung an bestimmten, individuellen Subpixeln zugeordneten Stellen innerhalb des Pixels kein physikalisches Subpixel aufzufinden ist. Je nach Herstellungsprozess kann es einfacher sein, den Licht emittierenden Bereich funktionsunfähig auszugestalten oder die Verdrahtung, das heißt, die Ansteuerleitungen entsprechend umzukonstruieren. In beiden Fällen, einem nicht funktionsfähigen Subpixel einerseits und der fehlenden Kontaktierung andererseits kann die Emission von Licht an diesem Ort vermieden werden.

Die Fig. 5a-d zeigen schematische Blockschaltbilder eines Anzeigesystems 50 gemäß einer Ausführungsform. Das Anzeigesystem 50 umfasst eine hierin beschriebene Anzeigeeinrichtung, beispielsweise die Anzeigeeinrichtung 40, wobei ohne Weiteres auch die Anzeigeeinrichtung 10 oder 20 verwendet werden kann. Ferner ist eine Steuerungseinrichtung 36 vorgesehen, die ausgebildet ist, um zumindest eine der Teilmengen der Anzeigeelemente als eine ausgewählte Teilmenge für eine Ansteuerung auszuwählen, etwa basierend auf einem Betriebszustand oder einer anzuzeigenden Information, einem Nutzersignal oder dergleichen. Die Steuerungseinrichtung ist ausgebildet, um die zumindest eine ausgewählte Teilmenge vermittels der Verschaltungseinrichtung 14 gemeinsam anzusteuern. So kann beispielsweise zum Darstellen des Musters 26₁ eine Kontaktierung der Ansteuerleitung 16₁ und der Rückleitung 28 erfolgen. Zum Darstellen des Musters 26₂ kann die Ansteuerungsleitung 16₂ und die Rückleitung 28 kontaktiert werden. Zum Darstellen des Musters 26₃ kann die Ansteuerleitung 16₃ und die Rückleitung 28 kontaktiert werden. Zum Darstellen des Musters 26₄ kann die Ansteuerleitung 16₄ und die Rückleitung 28 angesteuert werden. Wie es im Zusammenhang mit den Fig. 4a-d beschrieben ist, kann die Steuerungseinrichtung 36 auch mehrere der Ansteuerleitungen 16₁ bis 16₄ zu einem Zeitpunkt gleichzeitig ansteuern, etwa um eine Überlagerung mehrerer Muster 26₁ bis 26₄ darzustellen. Dies ist insbesondere von Vorteil, wenn eines oder mehrere der Muster in Kombination mit der Verwendung eines Farbfilters und/oder eines Helligkeitsdämpfers projiziert werden, die von der Steuerungseinrichtung 36 ebenfalls angesteuert werden können.

Gemäß einem Ausführungsbeispiel ist die Steuerungseinrichtung 36 ausgebildet, um die ausgewählte Teilmenge vermittels eines gemeinsamen und der ausgewählten Teilmenge eindeutig zugeordneten Schaltkontaktes 16₁ bis 16₄ der Verschaltungseinrichtung 14 anzusteuern.

Gemäß einem Ausführungsbeispiel, das alternativ oder zusätzlich implementiert werden kann, ist die Steuerungseinrichtung 36 ausgebildet, um eine Helligkeit und/oder eine Farbe eines mit der Anzeigeeinrichtung dargestellten Musters zu steuern, etwa indem die optionalen Farbfilter und/oder Helligkeitsdämpfer angesteuert werden.

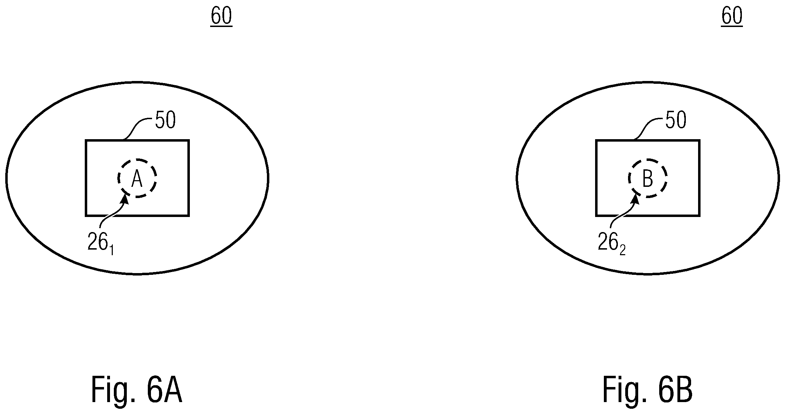

Fig. 6a zeigt ein schematisches Blockschaltbild eines Multifunktionselementes 60 gemäß einem Ausführungsbeispiel. Das Multifunktionselement 60 kann zum Einsatz in einem System geeignet sein, beispielsweise ein Bedienelement, wie eine Taste oder ein Knopf. Andere Multifunktionselemente können beispielsweise Klappen, Regler, Schieber oder dergleichen umfassen. Das Multifunktionselement 60 umfasst ein hierin beschriebenes Anzeigesystem, etwa das Anzeigesystem 50. Das Multifunktionselement ist ausgebildet, um abhängig von einem Betriebszustand des Systems eine dem Betriebszustand zugeordnete Teilmenge von Anzeigeelementen anzusteuern, so dass die Anzeigeeinrichtung ein dem Betriebszustand zugeordnetes Muster darstellt. Beispielsweise kann das Multifunktionselement in dem in der Fig. 6a dargestellten Betriebszustand ein erstes Muster 26₁, repräsentiert durch "A", darstellen.

Fig. 6b zeigt ein schematisches Blockschaltbild des Multifunktionselementes 60 in einem anderen Betriebszustand des Systems, bei dem vermittels des Anzeigesystems 50 ein anderes Muster 26₂, repräsentiert durch "B", dargestellt wird.

In anderen Worten eignet sich die Technologie der hierin beschriebenen Ausführungsbeispiele beispielsweise für Multifunktionsknöpfe an Geräten. Wenn in einem Knopf mehrere Funktionen integriert werden, zwischen denen beispielsweise durch Drehen oder Drücken des Knopfs hin und her gewechselt werden kann, so kann die hier vorgestellte Display-Technologie im Knopf verbaut werden und so immer ein entsprechendes Symbol zur ausgewählten Funktion anzeigen.

Ein hierin beschriebenes Multifunktionselement kann in unterschiedlichen Anwendungsbereichen zum Einsatz kommen. Beispielsweise kann ein Bedienelement, etwa ein Steuerungsknopf, in einem ersten Betriebszustand einer Klimaanlage eine Temperatur, repräsentiert mit einem ersten Muster 26₁, steuern und in einem anderen Betriebszustand einen Volumenstrom, was mit einem anderen Muster 26₂, das an oder in dem Multifunktionselement dargestellt wird, angezeigt werden kann. Ein entsprechendes Multifunktionselement, insbesondere ein Betätigungsknopf kann platzsparend zur Darstellung einer Vielzahl von Informationen genutzt werden.

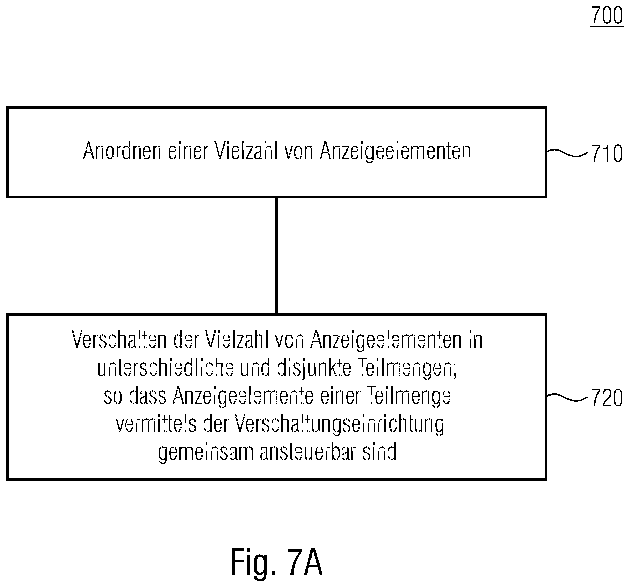

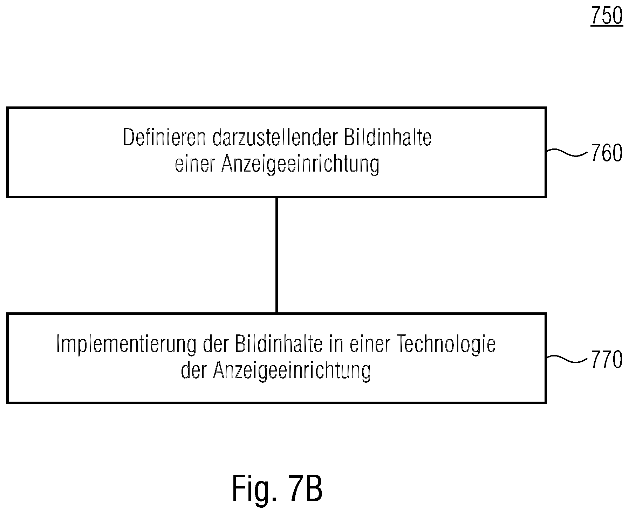

Fig. 7 zeigt ein schematisches Ablaufdiagramm eines Verfahrens 700 gemäß einem Ausführungsbeispiel, das beispielsweise zum Herstellen einer hierin beschriebenen Anzeigeeinrichtung verwendet werden kann. In einem Schritt 710 erfolgt ein Anordnen einer Vielzahl von Anzeigeelementen. In einem Schritt 720 erfolgt ein Verschalten der Vielzahl von Anzeigeelementen in unterschiedliche und disjunkte Teilmengen, so dass Anzeigeelemente einer Teilmenge vermittels der Verschaltungseinrichtung gemeinsam ansteuerbar sind. Bevorzugt werden bei der Ansteuerung einer Teilmenge Anzeigeelemente anderer Teilmengen inaktiv gehalten bzw. nicht angesteuert, sofern die Teilmengen, denen diese Anzeigeelemente zugeordnet sind, nicht kombinatorisch angesteuert werden, wie es im Zusammenhang mit den Fig. 4a-5d beschrieben ist. Eine Reihenfolge der Schritte 710 und 720 kann beliebig sein und auch zumindest in Teilen gleichzeitig erfolgen. Beispielsweise kann im Fall des Weglassens einer µLED, etwa durch nicht-Anordnen des Leuchtelements 24 in Fig. 1b-c oder bei einem nicht-Öffnen des Isolators 17 in Fig. 1b-c die Verschaltung ausgeführt werden, jedoch das aktive Leuchtelement weggelassen, womit der Schritt 720 vor dem 710 Schritt 710 ausgeführt werden kann.

Ein Ausführungsbeispiel der vorliegenden Erfindung bezieht sich auf ein Verfahren 750, das einen Schritt 760 umfasst, in welchem darzustellende Bildinhalte einer Anzeigeeinrichtung definiert werden, etwa indem ein Layout umfassend die darzustellenden Symbole erstellt wird. In einem Schritt 770 erfolgt eine Implementierung der Bildinhalte in einer Technologie der Anzeigeeinrichtung, etwa µLED oder OLED, d. h., das Herstellen der Anzeigeeinrichtung, wobei die Bildinhalte damit fest und womöglich unveränderlich festgelegt werden. Ein solches Verfahren ist in Fig. 7b dargestellt.

Gemäß einer optionalen Ausgestaltung des Verfahrens 700 erfolgt ein Anordnen eines einheitlichen Farbfilters für Anzeigeelemente einer Teilmenge unter Anwendung eines Druckverfahrens oder unter Anwendung einer Transfertechnik.

Beispielsweise kann das Anordnen eines einheitlichen Farbfilters so ausgeführt werden, dass an unterschiedlichen Teilmengen von Anzeigeelementen unterschiedliche und jeweils einheitliche Farbfilter angeordnet werden, etwa vermittels Druckverfahren oder einer gleichen oder unterschiedlicher Transfertechniken.

Gemäß einem Ausführungsbeispiel kann das Verfahren 700 mit einem optionalen Schritt ausgestaltet werden, bei dem ein Anordnen eines Helligkeitsdämpfungselementes für zumindest eines der Vielzahl von Anzeigeelementen erfolgt.

Hierin beschriebene Ausführungsbeispiele lösen das technische Problem, eine Display-technologie mit annehmbarer Auflösung und ausreichenden Darstellungsmöglichkeiten in begrenztem Bauraum zu schaffen. Fortgeschrittene Displaytechnologien benötigen aufwendige Ansteuerungselektroniken, die wiederum größere Flächen und Volumen im Endprodukt in Anspruch nehmen. Zudem sind diese aufgrund der Kosten nur in hochpreisigen bzw. hochwertigen Produkten einsetzbar. Dagegen kommen einfache Displays, beispielsweise sogenannte 7-Segment-Anzeigen aufgrund der sehr begrenzten Darstellungsmöglichkeiten nur für sehr wenige Anwendungsmöglichkeiten in Frage. Diese Nachteile werden durch die hierin beschriebenen Ausführungsbeispiele beseitigt. Ausführungsbeispiele vereinen die einfache Integrationsmöglichkeit der direkt angesteuerten Anzeigen mit den hochauflösenden Fähigkeiten von Matrix-basierten Displays. Durch die hohe Auflösung ist es vor allem möglich, einzelne Symbole virtuell am gleichen Ort erscheinen zu lassen, wie es im Zusammenhang mit der Verwendung von Subpixeln beschrieben ist. Hierzu werden benachbarte Pixel nach einem bevorzugt festen, regelmäßigen Muster jeweils einem unterschiedlichen Symbol zugeordnet. Die Ansteuerung erfolgt jeweils über zugeordnete Spalten. Die Form und Gestaltung der darzustellenden Symbole ist relativ frei, wodurch ein breites Spektrum an Bildern umgesetzt werden kann. Die Einzelbilder können im Display mit Hilfe von Subpixeln innerhalb der Pixel umgesetzt werden, siehe hierzu die Ausführungen zu Fig. 4a bis Fig. 4b.

In der Herstellungstechnologie oder Technologie werden pro Pixel die entsprechenden Leuchtflächen, die zur Darstellung der Bilder benötigt werden, zur Verfügung gestellt. Die Zuweisung, welches Subpixel für welches Bild eingesetzt oder benötigt wird, kann zuvor in einem entsprechenden Layout definiert und somit jedes Bild fixiert werden. Auch die Ausgestaltung bzw. Form der einzelnen Leuchtflächen eines jeden Subpixels können individuell angepasst werden, so dass eine noch präzisere Darstellung des angezeigten Bildes ermöglicht wird.

Die Anzahl der Subpixel pro Pixel ergibt dabei die Anzahl der Bilder, die mit dem entsprechenden Display bzw. Pixel dargestellt werden können. Sofern eine derartig feste Zuordnung gewünscht oder implementiert ist, kann beispielsweise in einem Pixel gemäß der Fig. 3b eine höhere Anzahl von Bildern dargestellt werden als in der Ausführung gemäß der Fig. 3a.

Durch diese vordefinierten und überlagerten Bilder kann sich eine Ansteuerung ergeben, die in ihrer Komplexität stark gegenüber bekannten Konzepten verringert ist. Pro angezeigtem Bild wird lediglich ein Kontakt benötigt, welcher die entsprechenden Subpixel ansteuert und ein Kontakt, welcher beispielsweise die Kathode der LEDs anbindet, etwa die Rückleitung 28. Eine entsprechend inverse Ansteuerung ist ohne weiteres möglich. Bei einer 4x4-Pixelmatrix, die beispielhaft im Zusammenhang mit der Anzeigeeinrichtung 40 beschrieben ist, können somit bereits fünf Zuleitungen am Display ausreichen, da die Kathode bzw. der Kathodenanschluss für alle Subpixel gleich ausgeführt sein kann bzw. miteinander verbunden werden kann.

Die Helligkeit einzelner Leuchtflächen kann für jedes Subpixel gleich sein oder durch verschiedene technologische Möglichkeiten variiert werden. Ähnlich zu den Bildern kann die Helligkeit bereits über die Technologie oder Herstellungstechnologie eingestellt werden. Hierzu zählen, ähnlich wie zur Darstellung der Pixel, die Form und/oder Größe der Leuchtflächen, die individuell angepasst werden können. Eine derartige Einstellbarkeit kann ebenfalls zur Definition der Helligkeit pro Subpixel verwendet werden oder aber ein definiertes programmierbares, etwa resistives Element, welches in Serie zur Versorgungsleitung geschaltet wird. Darüber hinaus kann auch ein programmierbares resistives Element in Serie zur Versorgungsleitung geschaltet werden, wodurch die Helligkeit im Betrieb des Displays festgelegt werden kann. Dieses resistive Element kann dabei vom Typ EPROM (Erasable Programmable Read-Only Memory, löschbarer programmierbarer Nur-Lese-Speicher), EEPROM (Electrically Erasable Programmable Read-Only Memory, elektrisch löschbarer programmierbarer Festwertspeicher) Flash- oder ferroelektrischer Transistor sein. Des Weiteren kann ein solches resistives Element auch ein Phasenwechselspeicher oder ein anderweitiges nichtflüchtiges physikalisches, chemisches, optisches oder sonstiges Bauteil sein oder umfassen. Ein solches resistives Element kann ausgebildet sein, um die Anzeigeelemente zu schalten, also bspw. den Betriebszustand abhängig vom eingestellten Widerstandswert zwischen "Ein" und "Aus" zu wechseln. Dies schließt eine Helligkeitsregelung bis zu einer Verringerung bis hin zu einem Aus-Zustand mit ein. Alternativ oder zusätzlich ist die aufgezeigte Technologie auch in Verbindung mit helligkeitsdämpfenden Elementen verwendbar, welche individuell in Abstrahlrichtung auf der Leuchtfläche angebracht werden können und wodurch ebenfalls die Helligkeit einer jeden Leuchtfläche definiert werden kann.

Hinsichtlich der Farbgebung jedes wiedergebenden Bildes ist es möglich, dass jedes Leuchtelement, Anzeigeelement, einer zugehörigen Ansteuerleitung mit einem möglicherweise einheitlichen Farbbild dargelegt wird. Dieses Farbfilter kann zum einen durch ein Druckverfahren, speziell Tintenstrahldruck, mit entsprechenden Vorrichtungen hinsichtlich Steuerung der Tintenausbreitung und Trocknungsverhalten realisiert werden. Dabei kann jedes Leuchtelement individuell bedruckt werden oder mehrere Elemente in einem gemeinsamen Vorgang. Zum anderen kann ein entsprechendes Filterelement mittels Transfertechnik auf einen, mehrere oder jeden Leuchtpunkt platziert werden, wobei dies auch pro Subpixel oder in einem parallelisierten Verfahren erfolgen kann.

Eine weitere Besonderheit hierin vorgeschlagener Anzeigeeinrichtungen/Displays ist die direkte Kompatibilität zur Herstellung von aufwendigeren Matrix-Displays. Bei gleicher Dimensionierung der Pixel kann es ausreichend sein, lediglich Gruppen von Spaltenleitungen zu gemeinsamen Versorgungsanschlüssen zusammenzufassen. Zusätzliche Speicher/Treiberelemente und Zeilenleitungen können entfallen, der Herstellungsprozess wird damit stark vereinfacht.

Die hierin beschriebene Displaytechnologie kann ebenfalls auf unterschiedlichen Substratoberflächen realisiert werden. So können durch geeignete Wahl, auch hinsichtlich der späteren Applikation, weitere Eigenschaften wie z. B. Transparenz, etwa durch Glassubstrate, Dehnbarkeit, Biegsamkeit, etwa durch Polymersubstrate, integriert werden und/oder andere Anforderungen berücksichtigt werden.

Ein wesentlicher Vorteil der Technologie ist die geringe Komplexität der Ansteuerung, welche die einer 7-Segment-Anzeige noch unterbieten kann. Pro angezeigtem Bild wird lediglich eine Zuleitung benötigt. Eine für den Displaybetrieb notwendige Kathode kann für alle Bilder verwendet werden. Schon bei einer 7-Segment-Anzeige wird jedes Segment mit einer Zuleitung angesteuert und es benötigt in der Regel mehrere Segmente, um ein Symbol zu erzeugen. Während zudem bei solchen Anzeigen die Darstellungsmöglichkeiten stark begrenzt sind, kann mit der hierin beschriebenen Ausgestaltung einer Anzeigeeinrichtung nahezu jedes Symbol hochaufgelöst erzeugt werden. Das bietet wiederum den Vorteil, dass kein Passiv-Matrix-Display bzw. Aktiv-Matrix-Display verwendet werden muss, welches in seiner Komplexität und den Herstellungskosten die hierin beschriebenen Ausführungsbeispiele bei Weitem übertreffen würde.

In der Folge der geringen Komplexität der Ansteuerung und der gleichzeitig möglichen Hochauflösung ergibt sich der weitere Vorteil, dass das Display in Applikationen mit sehr begrenztem Bauraum integriert werden kann. Zudem können durch Verwendung des entsprechenden Substratmaterials auch transparente Anwendungen oder die Integration auf gekrümmten Oberflächen umgesetzt werden.

Ausführungsbeispiele eignen sich zur Verwendung einer Display-Technologie vor allem für begrenzten Bauraum und kann zur weiteren Platzersparnis bzw. auch der Aufwertung von elektronischen Ausstattungselementen dienen. Mehrere Anzeigen, die nebeneinander platziert sind, können mithilfe des Displays in einer Anzeige umgesetzt werden, etwa Kontrolllampen, insbesondere im Automotive-Bereich. Gemäß den Anwendungsbeispielen können Knöpfe und Kontrolleinheiten aufgewertet und die ihren Funktionen entsprechenden Symbole angezeigt werden. Zudem eignet sich die Technologie für jedes Anwendungsgebiet, bei dem ein technologisch aufwendiges Display aufgrund der verursachten Kosten nicht lohnend ist.

Im Folgenden werden zusätzliche Ausführungsbeispiele und Aspekte der Erfindung beschrieben, die einzeln oder in Kombination mit beliebigen der hierin beschriebenen Merkmale, Funktionalitäten und Einzelheiten verwendet werden können.

Gemäß einem ersten Aspekt weist eine Anzeigeeinrichtung 10; 20; 40 Folgendes auf: eine Vielzahl von Anzeigeelementen 12; und eine Verschaltungseinrichtung 14, die ausgebildet ist, um unterschiedliche und disjunkte Teilmengen der Anzeigeelemente 12 miteinander zu verschalten; wobei Anzeigeelemente 12 einer Teilmenge vermittels der Verschaltungseinrichtung 14 gemeinsam ansteuerbar sind.

Gemäß einem zweiten Aspekt unter Rückbezug auf den ersten Aspekt ist die Verschaltungseinrichtung 14 ausgebildet, um die Teilmengen unveränderlich miteinander zu verschalten.

Gemäß einem dritten Aspekt unter Rückbezug auf den zweiten Aspekt ist die Verschaltungseinrichtung 14 ausgebildet, um die Teilmengen mittels einer festen Verdrahtung zu verschalten.

Gemäß einem vierten Aspekt unter Rückbezug auf einen des ersten bis dritten Aspekts ist die Vielzahl von Anzeigeelementen 12 in einem regelmäßigen Array mit einer Mehrzahl an Spalten und einer Mehrzahl an Zeilen angeordnet.

Gemäß einem fünften Aspekt unter Rückbezug auf einen des ersten bis vierten Aspekts ist jede der Teilmengen einem mit der Anzeigeeinrichtung dazustellenden vordefinierten Muster 26 eindeutig zugeordnet; wobei die Anzeigeeinrichtung ausgebildet ist, um das der Teilmenge zugeordnete vordefinierte Muster 26 vermittels der gemeinsamen Ansteuerung der Anzeigeelemente 12 darzustellen.

Gemäß einem sechsten Aspekt unter Rückbezug auf einen des ersten bis fünften Aspekts ist jede der Teilmengen von Anzeigeelementen 12 über eine der Teilgruppe eindeutig zugeordnete Ansteuerleitung 16 der Verschaltungseinrichtung 14 eindeutig ansteuerbar.

Gemäß einem siebten Aspekt unter Rückbezug auf einen des ersten bis sechsten Aspekts ist ein erstes Farbfilter bezüglich Anzeigeelementen 12 einer ersten Teilmenge von Anzeigeelemente 12 angeordnet; und ein zweites Farbfilter bezüglich Anzeigeelemente 12 einer zweiten Teilmenge von Anzeigeelementen 12 angeordnet ist.

Gemäß einem achten Aspekt unter Rückbezug auf einen des ersten bis siebten Aspekts weist die Anzeigeeinrichtung zumindest ein Farbfilter auf, das bezüglich zumindest eines Anzeigeelementes 12 entgegengesetzt zu einer Betrachtungsrichtung angeordnet ist, und ausgebildet ist, um ein von dem Anzeigeelement bereitgestelltes Licht zu filtern.

Gemäß einem neunten Aspekt unter Rückbezug auf einen des ersten bis achten Aspekts weist die Anzeigeelemente 12 einer Teilmenge eine gemeinsame Kontaktierung 16 auf, und bei einer Beschaltung der gemeinsamen Kontaktierung 16 entweder keines der Anzeigeelemente 12 der Teilmenge aktiviert wird oder alle Anzeigeelemente 12 der Teilmenge aktiviert werden.

Gemäß einem zehnten Aspekt unter Rückbezug auf den neunten Aspekt weist jedes Anzeigeelement 12 einen ersten elektrischen Anschluss 32 und einen zweiten elektrischen Anschluss 34 auf, wobei erste Anschlüsse 32 unterschiedlicher Anzeigeelemente 12 einer Teilmenge der Anzeigeelemente 12 vermittels der Verschaltungseinrichtung 14 mit einander verschaltet und von ersten Anschlüssen 32 von Anzeigenelementen 12 anderer Teilgruppen elektrisch getrennt sind; wobei zweite Anschlüsse 34 von Anzeigenelementen 12 unterschiedlicher Teilmengen vermittels der Verschaltungseinrichtung 14 mit einander verschaltet sind.

Gemäß einem elften Aspekt unter Rückbezug auf einen des ersten bis zehnten Aspekts ist die Vielzahl von Anzeigeelementen 12 eine erste Vielzahl von Subpixeln, wobei die Vielzahl von Subpixeln in eine zweite Vielzahl von Pixeln gruppiert ist; wobei jede Teilmenge von Anzeigeelementen 12 höchstens ein Subpixel eines Pixels umfasst.

Gemäß einem zwölften Aspekt unter Rückbezug auf den elften Aspekt werden bei einer Ansteuerung unterschiedlicher Teilmengen der Anzeigeelemente 12 unterschiedliche Subpixel eines Pixels angesteuert.

Gemäß einem dreizehnten Aspekt unter Rückbezug auf den elften oder zwölften Aspekt weist jedes Pixel der zweiten Vielzahl von Pixeln eine übereinstimmende Anzahl von Subpixeln auf.

Gemäß einem vierzehnten Aspekt unter Rückbezug auf einen des ersten bis dreizehnten Aspekts weist die Vielzahl von Anzeigeelementen 12 eine hinsichtlich eines Flächenbereichs übereinstimmende oder eine individuelle Anzeigeoberflächengeometrie und/oder Flächeninhalt auf.

Gemäß einem fünfzehnten Aspekt unter Rückbezug auf einen des ersten bis vierzehnten Aspekts ist die Vielzahl von Anzeigeelementen 12 für eine Bereitstellung einer übereinstimmenden, einer gruppenweise übereinstimmenden oder einer individuellen Anzeigehelligkeit ausgebildet.

Gemäß einem sechzehnten Aspekt unter Rückbezug auf einen des ersten bis fünfzehnten Aspekts weist die Anzeigeeinrichtung ein resistives Element auf, das als Teil von oder seriell zu einer Versorgungsleitung zumindest einer der Teilmengen von Anzeigeelementen 12 verschaltet ist, und ausgebildet ist, um eine Helligkeit der Anzeigeelemente einzustellen oder die Anzeigeelemente zu schalten.

Gemäß einem siebzehnten Aspekt unter Rückbezug auf den sechzehnten Aspekt ist das resistive Element ein steuerbares Element, insbesondere ein programmierbares resistives Element.

Gemäß einem achtzehnten Aspekt unter Rückbezug auf einen des ersten bis siebzehnten Aspekts weist die Anzeigeeinrichtung zumindest ein Helligkeitsdämpfungselement auf, das bezüglich zumindest einem der Anzeigeelemente 12 entgegengesetzt zu einer Betrachtungsrichtung angeordnet ist, und ausgebildet ist, um eine von dem Anzeigeelement bereitgestellte Helligkeit entgegengesetzt zu der Betrachtungsrichtung zu dämpfen.

Gemäß einem neunzehnten Aspekt unter Rückbezug auf den achtzehnten Aspekt ist das Helligkeitsdämpfungselement bezüglich eines Dämpfungsgrades, mit welchem die Helligkeit des Anzeigeelementes 12 gedämpft wird, steuerbar.

Gemäß einem zwanzigsten Aspekt unter Rückbezug auf einen des ersten bis neunzehnten Aspekts weist Anzeigeeinrichtung eine Vielzahl von Sensorelementen auf, wobei jedes Sensorelement der Vielzahl von Sensorelementen exakt einer Teilmenge von Anzeigeelementen 12 zugeordnet ist; oder in eine aus zumindest einer Gruppe von Sensorelementen zusammengeschaltet ist.

Gemäß einem einundzwanzigsten Aspekt unter Rückbezug auf einen des ersten bis zwanzigsten Aspekts weist die Anzeigeeinrichtung zumindest einen Teilbereich einer Anordnung der Anzeigeelemente 12 auf, der einem Anzeigeelement in der Anordnung zugeordnet ist und hinsichtlich einer Funktion zum Anzeigen funktionsunfähig gebildet ist.

Gemäß einem zweiundzwanzigsten weist ein Anzeigesystem 50 Folgendes auf: eine Anzeigeeinrichtung 10; 20; 40 gemäß einem der vorangehenden Aspekte; und eine Steuerungseinrichtung 36, die ausgebildet ist, um zumindest eine der Teilmengen der Anzeigeelemente 12 als eine ausgewählte Teilmenge für eine Ansteuerung auszuwählen und um die zumindest eine ausgewählte Teilmenge vermittels der Verschaltungseinrichtung 14 gemeinsam anzusteuern.

Gemäß einem dreiundzwanzigsten Aspekt unter Rückbezug auf den zweiundzwanzigsten Aspekt ist die Steuerungseinrichtung 36 ausgebildet, um die ausgewählte Teilmenge vermittels eines gemeinsamen und der ausgewählten Teilmenge eindeutig zugeordneten Schaltkontaktes 16 der Verschaltungseinrichtung 14 anzusteuern.

Gemäß einem vierundzwanzigsten Aspekt unter Rückbezug auf den zweiundzwanzigsten oder dreiundzwanzigsten Aspekt ist die Steuerungseinrichtung 36 ausgebildet, um eine Helligkeit und/oder eine Farbe eines mit der Anzeigeeinrichtung 10; 20; 40 dargestellten Musters 26 zu steuern.

Gemäß einem fünfundzwanzigsten Aspekt weist ein Multifunktionselement 60 für ein System ein Anzeigesystem 50 gemäß einem des zweiundzwanzigsten bis vierundzwanzigsten Aspekts auf, wobei das Multifunktionselement 60 ausgebildet ist, um abhängig von einem Betriebszustand des Systems eine dem Betriebszustand zugeordnete Teilmenge von Anzeigeelementen 12 anzusteuern, so dass die Anzeigeeinrichtung 10; 20; 40 ein dem Betriebszustand zugeordnetes Muster 26 darstellt.

Gemäß einem sechsundzwanzigsten Aspekt unter Rückbezug auf den fünfundzwanzigsten Aspekt ist das Multifunktionselement 60 ein Betätigungsknopf.

Gemäß einem siebenundzwanzigsten Aspekt weist ein Verfahren 700 zum Herstellen einer Anzeigeeinrichtung folgende Schritte auf: Anordnen 710 einer Vielzahl von Anzeigeelementen; Verschalten 720 der Vielzahl von Anzeigeelementen in unterschiedliche und disjunkte Teilmengen; so dass Anzeigeelemente einer Teilmenge vermittels der Verschaltungseinrichtung gemeinsam ansteuerbar sind.

Gemäß einem achtundzwanzigsten Aspekt unter Rückbezug auf den siebenundzwanzigsten Aspekt umfasst das Verfahren ein Anordnen eines einheitlichen Farbfilters für Anzeigeelemente 12 einer Teilmenge unter Anwendung eines Druckverfahrens oder unter Anwendung einer Transfertechnik.

Gemäß einem neunundzwanzigsten Aspekt unter Rückbezug auf den achtundzwanzigsten Aspekt werden für unterschiedliche Teilmengen von Anzeigeelementen 12 unterschiedliche einheitliche Farbfilter angeordnet.

Gemäß einem dreißigsten Aspekt unter Rückbezug auf einen des siebenundzwanzigsten bis neunundzwanzigsten Aspekts umfasst das Verfahren ein Anordnen eines Helligkeitsdämpfungselements für zumindest eines der Vielzahl von Anzeigeelementen 12.

Gemäß einem einunddreißigsten Aspekt weist ein Verfahren 750 zum Herstellen einer Anzeigeeinrichtung folgende Schritte auf: Definieren 760 von Bildinhalten einer Anzeigeeinrichtung; und Implementierung 770 der Bildinhalte in einer Technologie der Anzeigeeinrichtung.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Referenzen

[1] Direct Drive, Multiplex, and Passive Matrix, Karlheinz Blankenbach, Andreas Hudak und Michael Jentsch, Handbook of Visual Display Technology, DOI 10.1007/978-3-319-14346-0_33
[2] Active Matrix Driving, Karlheinz Blankenbach in Handbook of Visual Display Technology, DOI 10.1007/978-3-319-14346-0_34
[3] Internetquelle: https://www.marquardt.com/loesungen/bedienelemente-hmi/touchbedieneinheiten

## Patentansprüche

1. Anzeigeeinrichtung (10; 20; 40) mit:
einer Vielzahl von Anzeigeelementen (12);
einer Verschaltungseinrichtung (14), die ausgebildet ist, um unterschiedliche und disjunkte Teilmengen der Anzeigeelemente (12) miteinander zu verschalten;
wobei Anzeigeelemente (12) einer Teilmenge vermittels der Verschaltungseinrichtung (14) gemeinsam ansteuerbar sind.

2. Anzeigeeinrichtung gemäß Anspruch 1, bei der die Verschaltungseinrichtung (14) ausgebildet ist, um die Teilmengen unveränderlich miteinander zu verschalten.

3. Anzeigeeinrichtung gemäß Anspruch 2, bei der die Verschaltungseinrichtung (14) ausgebildet ist, um die Teilmengen mittels einer festen Verdrahtung zu verschalten.

4. Anzeigeeinrichtung gemäß einem der vorangehenden Ansprüche, bei der jede der Teilmengen einem mit der Anzeigeeinrichtung dazustellenden vordefinierten Muster (26) eindeutig zugeordnet ist; wobei die Anzeigeeinrichtung ausgebildet ist, um das der Teilmenge zugeordnete vordefinierte Muster (26) vermittels der gemeinsamen Ansteuerung der Anzeigeelemente (12) darzustellen.

5. Anzeigeeinrichtung gemäß einem der vorangehenden Ansprüche, bei der jede der Teilmengen von Anzeigeelementen (12) über eine der Teilgruppe eindeutig zugeordnete Ansteuerleitung (16) der Verschaltungseinrichtung (14) eindeutig ansteuerbar ist.

6. Anzeigeeinrichtung gemäß einem der vorangehenden Ansprüche, bei der ein erstes Farbfilter bezüglich Anzeigeelementen (12) einer ersten Teilmenge von Anzeigeelemente (12) angeordnet ist; und ein zweites Farbfilter bezüglich Anzeigeelemente (12) einer zweiten Teilmenge von Anzeigeelementen (12) angeordnet ist; oder
wobei die Anzeigeeinrichtung mit zumindest einem Farbfilter gebildet ist, das bezüglich zumindest eines Anzeigeelementes (12) entgegengesetzt zu einer Betrachtungsrichtung angeordnet ist, und ausgebildet ist, um ein von dem Anzeigeelement bereitgestelltes Licht zu filtern.

7. Anzeigeeinrichtung gemäß einem der vorangehenden Ansprüche, bei der die Anzeigeelemente (12) einer Teilmenge eine gemeinsame Kontaktierung (16) aufweisen, und bei einer Beschaltung der gemeinsamen Kontaktierung (16) entweder keines der Anzeigeelemente (12) der Teilmenge aktiviert wird oder alle Anzeigeelemente (12) der Teilmenge aktiviert werden.

8. Anzeigeeinrichtung gemäß Anspruch 7, bei der jedes Anzeigeelement (12) einen ersten elektrischen Anschluss (32) und einen zweiten elektrischen Anschluss (34) aufweist, wobei erste Anschlüsse (32) unterschiedlicher Anzeigeelemente (12) einer Teilmenge der Anzeigeelemente (12) vermittels der Verschaltungseinrichtung (14) mit einander verschaltet und von ersten Anschlüssen (32) von Anzeigenelementen (12) anderer Teilgruppen elektrisch getrennt sind; wobei zweite Anschlüsse (34) von Anzeigenelementen (12) unterschiedlicher Teilmengen vermittels der Verschaltungseinrichtung (14) mit einander verschaltet sind.

9. Anzeigeeinrichtung gemäß einem der vorangehenden Ansprüche, wobei die Vielzahl von Anzeigeelementen (12) eine erste Vielzahl von Subpixeln ist,
wobei die Vielzahl von Subpixeln in eine zweite Vielzahl von Pixeln gruppiert ist;
wobei jede Teilmenge von Anzeigeelementen (12) höchstens ein Subpixel eines Pixels umfasst.

10. Anzeigeeinrichtung gemäß Anspruch 9, wobei bei einer Ansteuerung unterschiedlicher Teilmengen der Anzeigeelemente (12) unterschiedliche Subpixel eines Pixels angesteuert werden; und/oder
wobei jedes Pixel der zweiten Vielzahl von Pixeln eine übereinstimmende Anzahl von Subpixeln aufweist.

11. Anzeigeeinrichtung gemäß einem der vorangehenden Ansprüche, bei der die Vielzahl von Anzeigeelementen (12) eine hinsichtlich eines Flächenbereichs übereinstimmende oder eine individuelle Anzeigeoberflächengeometrie und/oder Flächeninhalt aufweisen; und/oder
bei der die Vielzahl von Anzeigeelementen (12) für eine Bereitstellung einer übereinstimmenden, einer gruppenweise übereinstimmenden oder einer individuellen Anzeigehelligkeit ausgebildet sind.

12. Anzeigeeinrichtung gemäß einem der vorangehenden Ansprüche, mit einem bevorzugt steuerbaren resistiven Element, das als Teil von oder seriell zu einer Versorgungsleitung zumindest einer der Teilmengen von Anzeigeelementen (12) verschaltet ist, und ausgebildet ist, um eine Helligkeit der Anzeigeelemente einzustellen oder die Anzeigeelemente zu schalten.

13. Anzeigeeinrichtung gemäß einem der vorangehenden Ansprüche, mit zumindest einem Helligkeitsdämpfungselement, das bezüglich zumindest einem der Anzeigeelemente (12) entgegengesetzt zu einer Betrachtungsrichtung angeordnet ist, und ausgebildet ist, um eine von dem Anzeigeelement bereitgestellte Helligkeit entgegengesetzt zu der Betrachtungsrichtung zu dämpfen.

14. Anzeigeeinrichtung gemäß Anspruch 13, bei der das Helligkeitsdämpfungselement bezüglich eines Dämpfungsgrades mit welchem die Helligkeit des Anzeigeelementes (12) gedämpft wird, steuerbar ist.

15. Anzeigeeinrichtung gemäß einem der vorangehenden Ansprüche, mit einer Vielzahl von Sensorelementen, wobei jedes Sensorelement der Vielzahl von Sensorelementen exakt einer Teilmenge von Anzeigeelementen (12) zugeordnet ist; oder in eine aus zumindest einer Gruppe von Sensorelementen zusammengeschaltet ist.

16. Anzeigeeinrichtung gemäß einem der vorangehenden Ansprüche, mit zumindest einem Teilbereich einer Anordnung der Anzeigeelemente (12), der einem Anzeigeelement in der Anordnung zugeordnet ist und hinsichtlich einer Funktion zum Anzeigen funktionsunfähig gebildet ist.

17. Anzeigesystem (50) mit:
einer Anzeigeeinrichtung (10; 20; 40) gemäß einem der vorangehenden Ansprüche; und
einer Steuerungseinrichtung (36), die ausgebildet ist, um zumindest eine der Teilmengen der Anzeigeelemente (12) als eine ausgewählte Teilmenge für eine Ansteuerung auszuwählen und um die zumindest eine ausgewählte Teilmenge vermittels der Verschaltungseinrichtung (14) gemeinsam anzusteuern.

18. Anzeigesystem gemäß Anspruch 17, bei dem die Steuerungseinrichtung (36) ausgebildet ist, um die ausgewählte Teilmenge vermittels eines gemeinsamen und der ausgewählten Teilmenge eindeutig zugeordneten Schaltkontaktes (16) der Verschaltungseinrichtung (14) anzusteuern.

19. Multifunktionselement (60) für ein System, wobei das Multifunktionselement aufweist:
ein Anzeigesystem (50) gemäß Anspruch 17 oder 18,
wobei das Multifunktionselement (60) ausgebildet ist, um abhängig von einem Betriebszustand des Systems eine dem Betriebszustand zugeordnete Teilmenge von Anzeigeelementen (12) anzusteuern, so dass die Anzeigeeinrichtung (10; 20; 40) ein dem Betriebszustand zugeordnetes Muster (26) darstellt.
